(19) **Europäisches Patentamt**

**European Patent Office**

**Office européen des brevets**

(11) **EP 1 292 840 B1**

(12) **FASCICULE DE BREVET EUROPEEN**

(45) Date de publication et mention
de la délivrance du brevet:
**28.04.2004 Bulletin 2004/18**

(21) Numéro de dépôt: **01945373.7**

(22) Date de dépôt: **07.06.2001**

(51) Int Cl.⁷: $G01R\ 31/3183$

(86) Numéro de dépôt international:
**PCT/FR2001/001765**

(87) Numéro de publication internationale:
**WO 2001/094961 (13.12.2001 Gazette 2001/50)**

(54) **PROCEDE POUR METTRE EN EVIDENCE LA DEPENDANCE D'UN SIGNAL EN FONCTION D'UN AUTRE SIGNAL**

VERFAHREN ZUM NACHWEISEN DER ABHÄNGIGKEIT EINES SIGNALS VON EINEM ANDEREN SIGNAL

METHOD FOR DEMONSTRATING THE DEPENDENCE OF A SIGNAL BASED ON ANOTHER SIGNAL

(84) Etats contractants désignés:
**AT BE CH CY DE DK ES FI FR GB GR IE IT LI LU MC NL PT SE TR**

(30) Priorité: **08.06.2000 FR 0007355**

(43) Date de publication de la demande:
**19.03.2003 Bulletin 2003/12**

(73) Titulaire: **BULL S.A.**
**78430 Louveciennes (FR)**

(72) Inventeurs:
  • **AKLI, Florence**
    **F-78340 Les Clayes sous Bois (FR)**
  • **DEBREIL, Alain**
    **F-78370 Plaisir (FR)**
  • **NIQUET, Christian**
    **F-92340 Bourg la Reine (FR)**

(74) Mandataire: **Denis, Hervé et al**
**BULL S.A.**
**Département de la Propriété Intellectuelle**
**PC: P4/079**
**rue Jean Jaurès - BP 68**
**78340 Les Clayes-sous-Bois (FR)**

(56) Documents cités:
**US-A- 5 572 535**

• **STANION T: "TSUNAMI: A PATH ORIENTED SCHEME FOR ALGEBRAIC TEST GENERATION" INTERNATIONAL SYMPOSIUM ON FAULT TOLERANT COMPUTING SYSTEMS. (FTCS),US,LOS ALAMITOS, IEEE COMP. SOC. PRESS, vol. SYMP. 21, 25 juin 1991 (1991-06-25), pages 36-43, XP000242690 ISBN: 0-8186-2150-8**
• **FUMMI F ET AL: "A complete testing strategy based on interacting and hierarchical FSMs" INTEGRATION, THE VLSI JOURNAL,NL,NORTH-HOLLAND PUBLISHING COMPANY. AMSTERDAM, vol. 23, no. 1, 1 octobre 1997 (1997-10-01), pages 75-93, XP004100336 ISSN: 0167-9260**
• **BRYANT R E: "BINARY DECISION DIAGRAMS AND BEYOND: ENABLING TECHNOLOGIES FOR FORMAL VERIFICATION" IEEE/ACM INTERNATIONAL CONFERENCE ON COMPUTER-AIDED DESIGN,US,LOS ALAMITOS, IEEE COMP. SOC. PRESS, 5 novembre 1995 (1995-11-05), pages 236-243, XP000620913 ISBN: 0-8186-7213-7**
• **HOJATI R ET AL: "EARLY QUANTIFICATION AND PARTITIONED TRANSITION RELATIONS" PROCEEDINGS OF THE INTERNATIONAL CONFERENCE ON COMPUTER DESIGN. ICCD. VLSI IN COMPUTERS AND PROCESSORS,US,LOS ALAMITOS, IEEE COMP. SOC. PRESS, 7 octobre 1996 (1996-10-07), pages 12-19, XP000729882 ISBN: 0-8186-7554-3**

**Description**

Le domaine d'application de l'invention est celui d'un procédé pour indiquer une combinaison de signaux à appliquer à un élément physique pour obtenir un changement d'état d'un signal déterminé suite à un changement d'état d'un autre signal dont dépend le signal déterminé.

Dans des éléments physiques complexes, tels que tout ou partie de circuits à haute densité d'intégration, des signaux générés par ces éléments physiques peuvent dépendre de nombreux autres signaux. Il est alors difficile de savoir si l'élément physique se comporte correctement.

Après gravure dans le silicium de circuits électriques, il faut détecter les circuits mauvais afin d'éviter de les utiliser. La technique employée pour trier les bons circuits des mauvais circuits est celle qui consiste à appliquer des stimuli au circuit et à comparer leurs réponses à des valeurs précalculées.

Dans le cas d'un circuit purement combinatoire à deux cents entrées, il faudrait appliquer deux à la puissance deux cent combinaisons d'états binaires sur les entrées pour traiter tous les cas possibles. Un appareil de test fonctionnant à 50 MHz, nécessiterait mille ans pour tester un seul circuit. Ces chiffres augmentent exponentiellement lorsqu'il y a des états mémorisants dans le circuit.

Il est donc nécessaire de minimiser le nombre de combinaisons d'états binaires à appliquer sur des signaux du circuit, pour trouver les fautes possibles du circuit.

Pour un premier signal normalement généré par un élément physique en fonction d'autres signaux appliqués à cet élément physique, il est connu des brevets US5434794 et US5737242 d'utiliser des diagrammes de décision binaires pour déterminer des états binaires possibles du premier signal résultant de combinaisons d'états binaires d'un deuxième signal avec des états binaires de troisièmes signaux du circuit.

Il est connu de "TSUNAMI: A PATH ORIENTED SCHEME FOR ALGEBRAIC TEST GENERATION" INTERNATIONAL SYMPOSIUM ON FAULT TOLERANT COMPUTING SYSTEMS. (FTCS),US,LOS ALAMITOS, IEEE COMP. SOC. PRESS, vol. SYMP. 21, 25 juin 1991 (1991-06-25), pages 36-43, ISBN: 0-8186-2150-8 de générer toutes les combinaisons des signaux d'entrée qui rendent une faute observable à une sortie.

L'intérêt des diagrammes de décision binaires est de pouvoir représenter en mémoire d'ordinateur, de façon particulièrement compacte, les combinaisons d'états binaires de signaux menant à un état binaire déterminé du premier signal.

Cependant, les diagrammes de décision binaires de l'état de la technique donnent une image statique de combinaisons possibles d'états binaires d'un deuxième signal avec des troisièmes signaux menant à un état binaire déterminé du premier signal. Il se peut alors qu'une combinaison de premier état binaire du deuxième signal avec des états binaires de troisièmes signaux mène au même état binaire déterminé du premier signal qu'une combinaison de deuxième état binaire du deuxième signal avec d'autres états binaires de troisièmes signaux. D'autre part, on pourrait observer sur l'élément physique, l'état binaire déterminé du premier signal pour le premier état binaire ou le deuxième état binaire du deuxième signal alors que celui-ci ne résulte pas des combinaisons binaires pour lequel l'élément physique est conçu mais de fautes tels qu'un collage de signaux dans l'élément physique. On entend par collage de signal, le fait pour un signal d'être à un état non prévu au moment de la conception, par exemple celui qui résulte d'un court circuit ou d'une destruction.

Pour s'assurer que l'état d'un premier signal résulte effectivement de l'état d'un deuxième signal, il convient d'observer qu'une transition d'état du deuxième signal induit une transition d'état du premier signal, les états des autres signaux restant invariables. Si de plus, la transition du premier signal n'est pas conforme à la transition prévue, ceci est interprétable comme une erreur.

L'objet de l'invention est un procédé qui associe à un premier signal généré par un élément physique, deux diagrammes de décision binaire sur deux états binaires d'un deuxième signal,

- le premier diagramme de décision binaire comprenant :

    - un premier sous diagramme de décision binaire codant un premier ensemble des combinaisons d'états binaires de troisièmes signaux pour lesquelles le premier signal est à un premier état binaire ou à un deuxième état binaire lorsque le deuxième signal est au premier état binaire,
    - un deuxième sous diagramme de décision binaire codant un deuxième ensemble des combinaisons d'états binaires des troisièmes signaux pour lesquelles le premier signal est au premier état binaire ou au deuxième état binaire lorsque le deuxième signal est au deuxième état binaire,

- le deuxième diagramme de décision binaire comprenant :

    - un troisième sous diagramme de décision binaire codant un troisième ensemble des combinaisons d'états binaires des troisièmes signaux pour lesquelles le premier signal est au deuxième état binaire ou à un premier état non binaire lorsque le deuxième signal est au premier état binaire,

- un quatrième sous diagramme de décision binaire codant un quatrième ensemble des combinaisons d'états binaires des troisièmes signaux pour lesquelles le premier signal est au deuxième état binaire ou au premier état non binaire lorsque le deuxième signal est au deuxième état binaire.

Le procédé comprend au moins une étape qui effectue une combinaison logique du premier, du deuxième et d'au moins l'un des troisième ou quatrième sous diagramme de décision binaire, ladite combinaison logique comprenant une conjonction logique de trois des dits quatre sous diagrammes de décision binaire dans laquelle un des dits trois sous diagramme de décision binaire est complémenté, de façon à générer un cinquième sous diagramme de décision binaire qui code un cinquième ensemble de combinaisons d'états binaires des dits troisièmes signaux.

Si le sous diagramme de décision binaire complémenté est le deuxième sous diagramme de décision binaire, le cinquième ensemble des combinaisons d'états binaires des dits troisièmes signaux est tel que le premier signal n'est pas au premier état ou au deuxième état binaire lorsque le deuxième signal est au deuxième état binaire, une disjonction avec le premier et le quatrième sous diagramme de décision binaire non complémentés, fait que le cinquième ensemble de combinaisons d'états binaires des dits troisièmes signaux est tel que le premier signal est au premier état non binaire ou au deuxième état binaire lorsque le deuxième signal est au deuxième état binaire, que le premier signal est au premier état binaire ou au deuxième état binaire lorsque le deuxième signal est au premier état binaire. Ainsi, lorsque le deuxième signal est au premier état binaire, le premier signal est au premier ou au deuxième état binaire, lorsque le deuxième signal passe au deuxième état binaire, le premier signal passe au premier état non binaire.

Des solutions alternatives sont définies dans les revendications indépendantes 6 et 8.

Ainsi, pour tester si un signal déterminé de circuit complexe a un comportement correct, le procédé permet d'obtenir en mémoire d'ordinateur, un profil d'états d'autres signaux parmi lesquels une variation d'état d'un seul signal doit provoquer une variation d'état du signal déterminé, sur un échantillon physique du circuit. De façon à minimiser le temps de traitement et l'espace mémoire nécessaires à l'obtention de ce profil, le procédé utilise deux diagrammes de décision binaire débutant par une variable binaire du dit seul signal, avec chacun deux sous diagrammes de décision binaire. Le procédé combine les sous diagrammes de décision binaire de façon à ce que le signal déterminé soit à un premier état lorsque la variable binaire est à une première valeur et ne soit pas à ce premier état lorsque la variable binaire est à une deuxième valeur.

D'autres avantages et détails de l'invention seront mieux compris dans la description qui suit en référence aux figures où :

- la figure 1 représente des étapes de procédé pour associer à un premier signal, au moins deux diagrammes de décision binaire ;
- la figure 2 représente des étapes de procédé pour associer au premier signal, un autre diagramme de décision binaire pour lequel un changement d'état de deuxième signal provoque un changement d'état du premier signal à état fixé d'un ensemble de troisièmes signaux ;
- les figures 3 et 4 représentent des éléments physiques pour comprendre l'effet du procédé sur un exemple simple ;
- la figure 5 représente deux diagrammes de décision binaire obtenus au moyen du procédé de la figure 1, pour l'élément physique de la figure 3 ;
- la figure 6 représente un troisième diagramme de décision binaire obtenu au moyen du procédé de la figure 1, pour l'élément physique de la figure 3 ;
- la figure 7 représente un exemple de diagramme de décision binaire obtenu au moyen du procédé conforme à l'invention

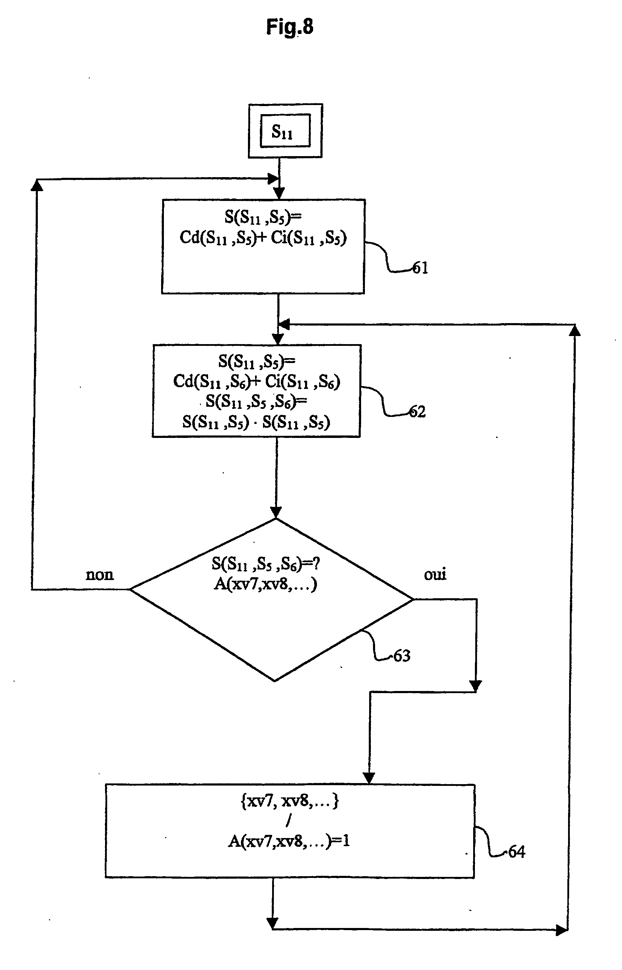

- la figure 8 représente des étapes supplémentaires d'un procédé conforme à l'invention.

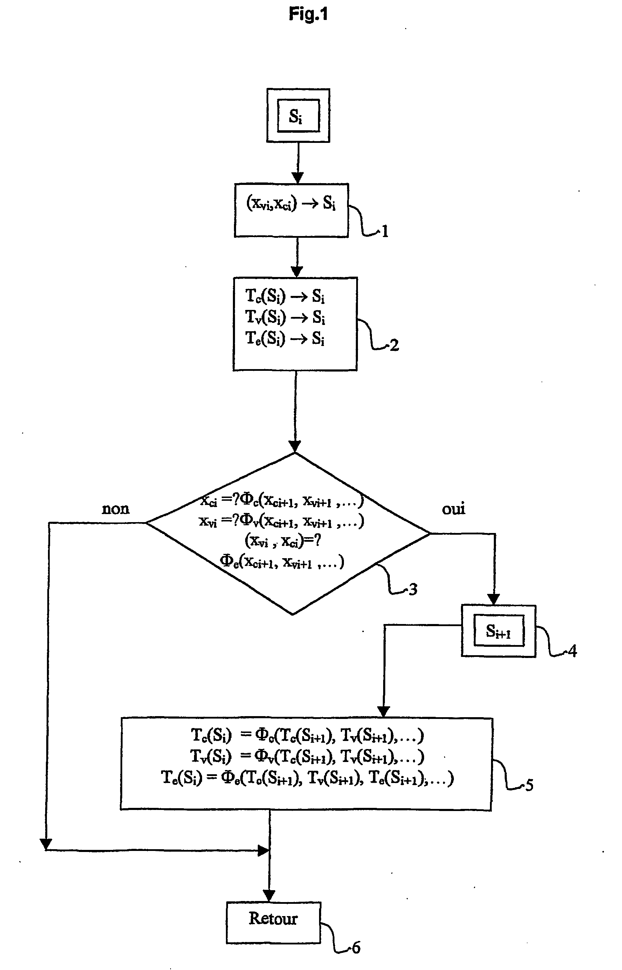

La figure 1 représente des étapes de procédé pour associer à un premier signal $s_i$, au moins deux diagrammes de décision binaire. Ces étapes sont exécutées par un ordinateur qui possède en mémoire une liste de connectique (netlist en anglais) de signaux et d'éléments physiques qui détermine différentes relations entre ces signaux. Les résultats intermédiaires et finaux des étapes sont automatiquement stockées en mémoire de l'ordinateur.

Dans une première étape 1, un couple de variables binaires $(x_{vi}, x_{ci})$ est attribué à un signal $s_i$ pour coder au moins trois états possibles du signal $s_i$. La variable $x_{ci}$, dite de contexte est définie pour indiquer que, lorsque sa valeur est égale à 1, les valeurs 0 et 1 de la variable $x_{vi}$ codent respectivement directement un premier état logique B et un deuxième état logique H du signal $s_i$. Lorsque la valeur de la variable de contexte $x_{ci}$ est égale à 0, les valeurs 0 et 1 de la variable $x_{vi}$ codent respectivement un état indéterminé et un état Z du signal $s_i$. L'état Z du signal $s_i$ est celui de haute impédance au sens où on l'entend habituellement dans un circuit électrique. Dans l'état indéterminé, on retrouve un état E d'erreur du signal $s_i$ telle que par exemple un court circuit électrique. Le couple de variables binaires $(x_{vi}, x_{ci})$ permet ainsi de coder quatre états possibles du signal $s_i$.

Dans une deuxième étape 2, trois diagrammes de décision binaire $T_v(s_i)$, $T_c(s_i)$, $T_e(s_i)$, sont attribués au signal $s_i$.

Le diagramme de décision binaire $T_c(si)$, dit de contexte, est construit au moyen d'une règle Rc, de façon à ce qu'il conduise à 1 si l'état du signal $s_i$ est l'état logique B ou l'état logique H.

Le diagramme de décision binaire $T_v(si)$, dit de valeur, est construit au moyen d'une règle Rv, de façon à ce qu'il conduise à 1 si l'état du signal $s_i$ est l'état de haute impédance Z ou l'état logique H.

Le diagramme de décision binaire $T_e(s_i)$, dit d'erreur, est construit au moyen d'une règle Re, de façon à ce qu'il conduise à 1 si l'état du signal $s_i$ est un état d'erreur.

L'application d'une règle Rc, Rv, Re, active une troisième étape 3 qui scrute la liste de connectique de façon à déterminer une combinaison $\Phi_c$, $\Phi_v$, $\Phi_e$ qui lie les états du signal $s_i$ aux états d'un ou plusieurs autres signaux $s_{i+1}$, $s_{i+2}$.

Lorsque le signai $s_i$ ne dépend d'aucun autre signal, chacune des variables $x_{vi}, x_{ci}$ du couple de variables binaires $(x_{vi}, x_{ci})$ peut prendre une valeur égale à 0 ou à 1. C'est par exemple le cas pour un signal d'entrée du circuit électrique ou pour un signal intermédiaire qu'il est possible de forcer au moyen d'une pointe de test. Les diagrammes de décision binaire $T_v(s_i)$, $T_c(s_i)$, sont tels que $T_v(s_i)$ conduit à 1 si $x_{vi}$ est égal à 1, $T_c(s_i)$ conduit à 1 si $x_{ci}$ est égal à 1. Les diagrammes de décision binaire étant alors immédiatement construits, une étape 6 de fin est activée.

Lorsque le signal $s_i$ dépend d'un ou plusieurs signaux $s_{i+1}$, $s_{i+2}$, une quatrième étape 4 met à disposition les diagrammes de décision binaire associés au signal $s_{i+1}$, $s_{i+2}$. Si les diagrammes de décision binaires existent déjà en mémoire, cette mise à disposition consiste en une simple lecture de pointeurs sur ces diagrammes de décision binaires. Si les diagrammes de décision binaires n'existent pas en mémoire, cette mise à disposition consiste à réactiver le procédé de façon récursive pour le ou les signaux $s_{i+1}$, $s_{i+2}$...

Une étape 5 combine alors les diagrammes de décision binaire au moyen des combinaisons déterminées en étape 3.

Rappelons qu'un diagramme de décision binaire $T_f$ associé à une première fonction booléenne f(a,b,c,...,w) de variables binaires a,b,c,...,w, est accessible au moyen d'une première structure de données informatiques qui permet de représenter en mémoire, les valeurs prises par la première fonction f selon les valeurs prises par les variables binaires a,b,c,...,w. Cette première structure de donnée est construite en utilisant les propriétés connues d'une décomposition de Shannon par rapport à une première variable a, à savoir, en utilisant les notations usuelles d'écriture des fonctions logiques:

$$f(a,b,c,..., w) = \bar{a} \cdot f(a=0,b,c,...,w) + a \cdot f(a=1,b,c,..., w)$$

où $f(a=0,b,c,...,w)$ est une deuxième fonction booléenne invariable selon a car a y est fixé à zéro et où $f(a=1,b,c,...,w)$ est une troisième fonction booléenne invariable selon a car a y est fixé à un. La deuxième fonction booléenne prend les mêmes valeurs que la première fonction booléenne selon les valeurs prises par les variables binaires b,c,...,w lorsque a=0. La troisième fonction booléenne prend les mêmes valeurs que la première fonction booléenne selon les valeurs prises par les variables binaires b,c,...,w lorsque a=1. La première structure de données se présente donc comme un triplet d'adresses de zones mémoire {a,f(a=0,b,...),f(a=1,b,...)} qui comprend alors un premier noeud occupé par la première variable a, un pointeur gauche sur une deuxième structure de données {b,f(a=0,b=0,...),f(a=0,b=1,...)} permettant d'accéder à un premier sous-diagramme de décision binaire associé à la deuxième fonction booléenne et un pointeur droit sur une troisième structure de données {b,f(a=1,b=0,...),f(a=1,b=1,...)} permettant d'accéder à un deuxième sous-diagramme de décision binaire associé à la troisième fonction booléenne. La deuxième et la troisième structure de données étant de même type que la première structure de donnée avec respectivement un deuxième et un troisième noeud occupé par une deuxième variable binaire b, c. L'opération ci dessus répétée jusqu'à la dernière variable binaire w donne le diagramme de décision binaire $T_f$ constitué par un enchaînement {a,{b,{...},{...}},{b,{...}, {...}}} des structures au moyen des pointeurs. Un identificateur du diagramme de décision binaire $T_f$ pointe sur le premier noeud alors appelé noeud racine.

La représentation en mémoire d'une fonction par un diagramme de décision binaire présente un avantage appréciable de compacité car si deux ou plusieurs sous-diagrammes de décision binaire sont identiques, une seule représentation en mémoire suffit, deux ou plusieurs pointeurs pouvant pointer sur une même structure de données. Lorsqu'une fonction est indépendante d'une variable binaire, le diagramme de décision binaire se simplifie de lui-même. La représentation en mémoire d'une fonction par un diagramme de décision binaire peut être implicite dans le sens où il est possible de faire des calculs sur le noeud racine sans développer nécessairement le diagramme de décision binaire pour tous les noeuds.

Une propriété intéressante des diagrammes de décision binaire résulte du constat suivant sur la décomposition de Shannon. Lorsqu'une fonction booléenne h(a,b,c,...,w) résulte d'une opération combinatoire $\Phi(f,g)$ d'une ou plusieurs fonctions booléennes f(a,b,c,...,w), g(a,b,c,...,w):

$$h(a,b,c,...,w) = \overline{a} \cdot h(a=0,b,c,...,w) + a \cdot h(a=1,b,c,...,w)$$
$$= \overline{a} \cdot \Phi(f(a=0,b,c,...,w),g(a=0,b,c,...,w)) + a \cdot \Phi(f(a=1,b,c,...,w),g(a=1,b,c,...,w))$$
$$= \Phi(\overline{a} \cdot f(a=0,b,c,...,w),\overline{a} \cdot g(a=0,b,c,...,w)) + \Phi(a \cdot f(a=1,b,c,...,w),a \cdot g(a=1,b,c,...,w))$$
$$= \Phi(\overline{a} \cdot f(a=0,b,c,...,w) + a \cdot f(a=1,b,c,...,w),\overline{a} \cdot g(a=0,b,c,...,w)) + a \cdot g(a=1,b,c,...,w))$$

Par exemple:

Lorsque $\Phi$ est un complément logique,

$$h(a,b,c,...,w) = \overline{f}(a,b,c,...,w)$$

$$\overline{f}(a,b,c,...,w) = \overline{\overline{a} \cdot f(a=0,b,c,...,w) + a \cdot f(a=1,b,c,...,w)}$$
$$= \overline{[\overline{a} \cdot f(a=0,b,c,...,w)]} \cdot \overline{[a \cdot f(a=1,b,c,...,w)]}$$
$$= [a + \overline{f(a=0,b,c,...,w)}] \cdot [\overline{a} + \overline{f(a=1,b,c,...,w)}]$$
$$= \overline{a} \cdot \overline{f}(a=0,b,c,...,w) + a \cdot \overline{f}(a=1,b,c,...,w)$$

Le diagramme de décision binaire associé au complément logique d'une fonction f comprend donc le même noeud occupé par la variable a que le diagramme de décision binaire associé à la fonction f où le pointeur sur le sous-diagramme de décision binaire associé à la fonction f pour a égal à zéro est remplacé par un pointeur sur un sous-diagramme de décision binaire associé au complément logique de la fonction f pour a égal à zéro, et où le pointeur sur le sous-diagramme de décision binaire associé à la fonction f pour a égal à un est remplacé par un pointeur sur un sous-diagramme de décision binaire associé au complément logique de la fonction f pour a égal à un.

Lorsque $\Phi$ est une disjonction logique de deux fonctions f et g,

$$h(a,b,c,...,w) = f(a,b,c,...,w) + g(a,b,c,...,w)$$

$$= \overline{a} \cdot [f(a=0,b,c,...,w) + g(a=0,b,c,...,w)] + a \cdot [f(a=1,b,c,...,w) + g(a=1,b,c,...,w)]$$

Le diagramme de décision binaire associé à la disjonction logique de deux fonctions f et g, comprend donc le même noeud occupé par la variable a que le diagramme de décision binaire associé à la fonction f où le pointeur sur le sous-diagramme de décision binaire associé à la fonction f pour a égal à zéro est remplacé par un pointeur sur un sous-diagramme de décision binaire associé à la disjonction logique de la fonction f pour a égal à zéro et de la fonction g pour a égal à zéro, et où le pointeur sur le sous-diagramme de décision binaire associé à la fonction f pour a égal à un est remplacé par un pointeur sur un sous-diagramme de décision binaire associé à la disjonction logique de la fonction f pour a égal à un et de la fonction g pour a égal à un.

Lorsque $\Phi$ est une conjonction logique de deux fonctions f et g,

$$h(a,b,c,...,w) = f(a,b,c,...,w) \cdot g(a,b,c,...,w)$$

$$= \overline{a} \cdot [f(a=0,b,c,...,w) \cdot g(a=0,b,c,...,w)] + a \cdot [f(a=1,b,c,...,w) \cdot g(a=1,b,c,...,w)]$$

Le diagramme de décision binaire associé à la conjonction logique de deux fonctions f et g, comprend donc le même noeud occupé par la variable a que le diagramme de décision binaire associé à la fonction f où le pointeur sur le sous-diagramme de décision binaire associé à la fonction f pour a égal à zéro est remplacé par un pointeur sur un sous-diagramme de décision binaire associé à la conjonction logique de la fonction f pour a égal à zéro et de la fonction g pour a égal à zéro, et où le pointeur sur le sous-diagramme de décision binaire associé à la fonction f pour a égal à un est remplacé par un pointeur sur un sous-diagramme de décision binaire associé à la conjonction logique de la fonction f pour a égal à un et de la fonction g pour a égal à un.

En procédant par récurrence jusqu'à la demière variable w de une ou plusieurs fonctions f, g, il est possible d'effectuer de façon simple toute opération combinatoire $\Phi$ d'un ou de plusieurs diagrammes de décision binaire.

Le diagramme de décision binaire $T_c(s_i)$ est construit au moyen de la combinaison $\Phi_c$ qui donne $T_v(s_i)$ en $x_{vi+1}$, $x_{ci+1}$, $x_{vi+2}$, $x_{ci+2}$ respectivement par les diagrammes de décision binaire $T_v(s_{i+1})$, $T_c(s_{i+1})$, $T_e(s_{i+1})$, $T_v(s_{i+2})$, $T_c(s_{i+2})$, $T_e(s_{i+2})$;

Le diagramme de décision binaire $T_v(s_i)$ est construit au moyen de la combinaison $\Phi_v$ qui donne $T_v(s_i)$ en remplaçant $x_{vi+1}$, $x_{ci+1}$, $x_{vi+2}$, $x_{ci+2}$ respectivement par les diagrammes de décision binaire $T_v(s_{i+1})$, $T_c(s_{i+1})$, $T_v(s_{i+2})$, $T_e(s_{i+2})$.

Le diagramme de décision binaire $T_e(s_i)$ est construit de même en combinant les diagrammes de décision binaire $T_v(s_{i+1})$, $T_c(s_{i+1})$, $T_e(s_{i+1})$, $T_v(s_{i+2})$, $T_c(s_{i+2})$, $T_e(s_{i+2})$.

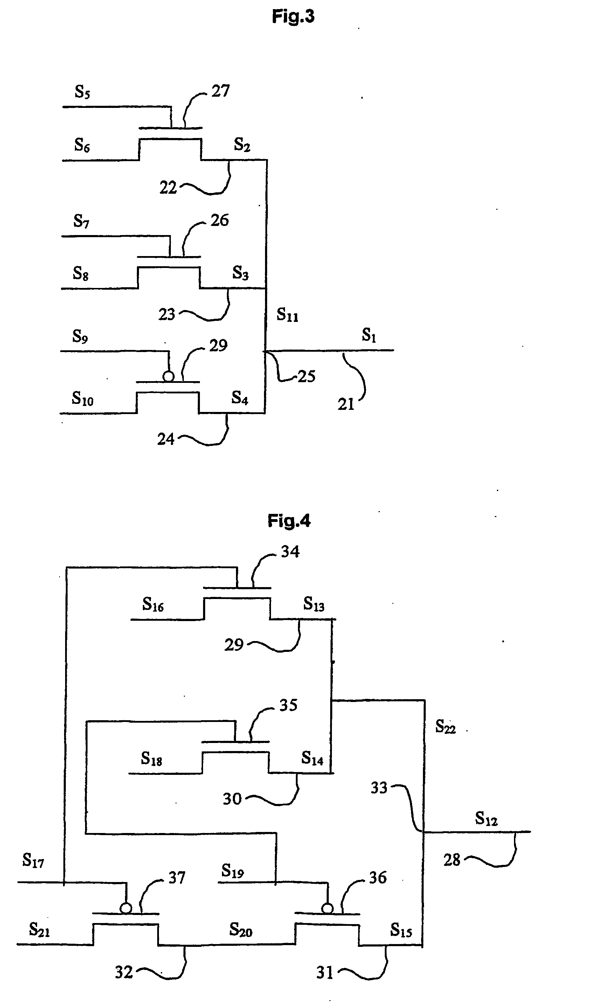

Appliquons par exemple le procédé précédemment décrit au circuit élémentaire de la figure 3 qui constitue un multiplexeur à trois entrées.

Un conducteur 21 véhicule un signal si. Le conducteur 21 est raccordé en un point 25, à trois conducteurs 22, 23, 24 en parallèle. Les conducteurs 22, 23, 24 véhiculent chacun respectivement un signal $s_2$, $s_3$, $s_4$. Le raccordement des signaux s2, s3 au point 25 est équivalent à un signal intermédiaire s11 raccordé au point 25 avec le signal s4.

La variable xv1 est égale à 1 si et seulement si l'état de chacun des signaux $s_2$, $s_3$, $s_4$ est l'état de haute impédance Z ou l'état logique H.

La règle Rv applicable pour construire le diagramme de décision binaire $T_v(s_{11})$ est une règle Rvr pour deux conducteurs raccordés en un même point 25:

$$T_v(s_{11})= T_v(s_2)\cdot T_v(s_3).$$

$T_v(s_{11})$ étant maintenant présent en mémoire, la règle Rvr est appliquée à nouveau à $s_{11}$ et $s_4$.

$$T_v(s_1)= T_v(s_{11})\cdot T_v(s_4).$$

Une erreur se produit sur le signal $s_{11}$ si l'un des signaux $s_2$, $s_3$, est à l'état logique H alors que l'autre signal $s_3$, $s_2$ est à l'état logique B, ou si l'un des signaux $s_2$, $s_3$, est à l'état d'erreur.

La règle Re applicable pour construire le diagramme de décision binaire $T_e(s_{11})$ est une règle Rer pour deux conducteurs raccordés au point 25:

$$Te(s11) = Tc(s2) \cdot Tc(s3) \cdot \left[Tv(s2)\cdot \overline{Tv(s3)} + \overline{Tv(s2)} \cdot Tv(s3)\right] + Te(s2) + Te(s3)$$

Une erreur se produit sur le signal $s_1$ si l'un des signaux $s_{11}$, $s_4$, est à l'état logique H alors que l'autre signal $s_4$, $s_{11}$ est à l'état logique B, ou si l'un des signaux $s_{11}$, $s_4$, est à l'état d'erreur.

La règle Rer est à nouveau applicable pour construire le diagramme de décision binaire $T_e(s_1)$

$$Te(s1) = Tc(s11) \cdot Tc(s4) \cdot \left[Tv(s11)\cdot \overline{Tv(s4)} + \overline{Tv(s11)} \cdot Tv(s4)\right] + Te(s11) + Te(s4)$$

La variable xc1 est égale à 1 si l'état du signal s1 est l'état B ou l'état H logique. Le signal s11 est à l'état B ou H si et seulement si le signal s2 ou le signal s3 est à l'état B ou H logique et si aucune erreur ne résulte des signaux s2 et s3 sur le signal s11. La règle Rc applicable pour construire le diagramme de décision binaire $T_c(s_{11})$ est une règle Rcr pour deux conducteurs raccordés au point 25:

$$Tc(s11) = \left[Tc(s2) + Tc(s3)\right] \cdot \overline{\left[Tc(s2) \cdot Tc(s3) \cdot \left[Tv(s2)\cdot \overline{Tv(s3)} + \overline{Tv(s2)} \cdot Tv(s3)\right]\right]}$$

$$Tc(s11) = \left[Tc(s2) + Tc(s3)\right] \cdot \left[\overline{\overline{Tc(s2)} + \overline{Tc(s3)}} + \overline{\overline{Tv(s2)} + Tv(s3)} \cdot \left[Tv(s2) + \overline{Tv(s3)}\right]\right]$$

$$Tc(s11) = \\ + Tc(s2) \cdot \left[\overline{Tc(s3)} + \overline{\overline{Tv(s2)} \cdot \overline{Tv(s3)}} + Tv(s2) \cdot Tv(s3)\right] \\ + Tc(s3) \cdot \left[\overline{Tc(s2)} + \overline{\overline{Tv(s2)} \cdot \overline{Tv(s3)}} + Tv(s2) \cdot Tv(s3)\right]$$

La règle Rcr est appliquée à nouveau pour les signaux s11 et s4:

$$Tc(s1) = \\ + Tc(s11) \cdot \left[\overline{Tc(s4)} + \overline{\overline{Tv(s11)} \cdot \overline{Tv(s4)}} + Tv(s11) \cdot Tv(s4)\right] \\ + Tc(s4) \cdot \left[\overline{Tc(s11)} + \overline{\overline{Tv(s11)} \cdot \overline{Tv(s4)}} + Tv(s11) \cdot Tv(s4)\right]$$

Si pour $s_2$, $T_v(s_2)$, $T_c(s_2)$, $T_e(s_2)$ ne sont pas présents en mémoire, la deuxième étape est répétée pour le signal $s_2$.

Le conducteur 22 est raccordé au drain d'un transistor 27 MOS de type N. La grille du transistor 27 reçoit un signal s5 et la source du transistor 27 reçoit un signal s6. En technologie CMOS, la notion de drain et de source d'un transistor est liée de façon connue à son régime de fonctionnement, aussi ces deux notions sont-elles interchangeables.

Le signal $s_2$ est à l'état H logique si et seulement si les signaux $s_5$ et $s_6$ sont à l'état H logique. Le signal $s_2$ est à l'état Z de haute impédance si et seulement si le signal $s_5$ est à l'état B logique ou si le signal $s_5$ est à l'état logique H et le signal $s_6$ est à l'état Z de haute impédance. La règle Rv qui s'applique est une règle Rvn:

$$Tv(s2) = \left[Tc(s5) \cdot Tv(s5) \cdot Tc(s6) \cdot Tv(s6) + Tc(s5) \cdot \overline{Tv(s5)}\right] + Tc(s5) \cdot Tv(s5) \cdot \overline{Tc(s6)} \cdot Tv(s6)$$

ce qui par simplification donne :

$$Tv(s2) = \left[Tc(s5) \cdot Tv(s5) \cdot Tv(s6) + Tc(s5) \cdot \overline{Tv(s5)}\right]$$

Le signal $s_2$ est à l'état E d'erreur si le signal $s_5$ est à l'état Z de haute impédance. En effet, une grille de transistor attaquée par un signal de haute impédance est particulièrement sensible au bruit. La règle Re qui s'applique est une règle Ren:

$$Te(s2) = Tv(s5) \cdot \overline{Tc(s5)}$$

Le signal $s_2$ est à l'état B ou H logique si et seulement si le signal $s_5$ est à l'état H logique et le signal $s_6$ est à l'état B ou H logique. La règle Rc qui s'applique est une règle Rcn:

$$Tc(s2) = Tc(s5) \cdot Tv(s5) \cdot Tc(s6)$$

Si pour $s_4$, $T_v(s_4)$, $T_c(s_4)$, $T_e(s_4)$ ne sont pas présents en mémoire, la deuxième étape est répétée pour le signal $s_4$.

Le conducteur 23 est raccordé au drain d'un transistor 26 MOS de type N. La grille du transistor 26 reçoit un signal s7 et la source du transistor 26 reçoit un signal s8.

Les deux premières étapes sont exécutées pour le signal s3 au moyen des mêmes règles Rvn, Rcn et Ren que pour le signal s2 de sorte à obtenir:

$$Tv(s3) = \left[ Tc(s7) \cdot Tv(s7) \cdot Tv(s8) + Tc(s7) \cdot \overline{Tv(s7)} \right]$$

$$Te(s3) = Tv(s7) \cdot \overline{Tc(s7)}$$

$$Tc(s3) = Tc(s7) \cdot Tv(s7) \cdot Tc(s8)$$

Le conducteur 24 est raccordé au drain d'un transistor 29 MOS de type P. La grille du transistor 29 reçoit un signal s9 et la source du transistor 27 reçoit un signal s10.

Le signal $s_4$ est à l'état H logique si et seulement si les signaux $s_9$ et $s_{10}$ sont respectivement à l'état B et H logique. Le signal $s_4$ est à l'état Z de haute impédance si et seulement si le signal $s_9$ est à l'état H logique ou si le signal s9 est à l'état B logique et le signal s10 est à l'état Z de haute impédance. Après simplification, la règle Rv qui s'applique est une règle Rvp:

$$Tv(s4) = \left[ Tc(s9) \cdot \overline{Tv(s9)} \cdot Tv(s10) + Tc(s9) \cdot Tv(s9) \right]$$

Le signal $s_4$ est à l'état E d'erreur si le signal $s_9$ est à l'état Z de haute impédance. En effet, une grille de transistor attaquée par un signal de haute impédance est particulièrement sensible au bruit La règle Re qui s'applique est une règle Rep:

$$Te(s4) = Tv(s9) \cdot \overline{Tc(s9)}$$

Le signal $s_4$ est à l'état B ou H logique si et seulement si le signal $s_9$ est à l'état B logique et le signal $s_{10}$ est à l'état B ou H logique. La règle Rc qui s'applique est une règle Rcp:

$$Tc(s4) = Tc(s9) \cdot \overline{Tv(s9)} \cdot Tc(s10)$$

On obtient ainsi les diagrammes de décision binaire $T_v(s_1)$, $T_c(s_1)$, $T_e(s_1)$ en fonction des diagrammes de décision binaire $T_v(s_5)$, $T_c(s_5)$, $T_v(s_6)$, $T_c(s_6)$, $T_v(s_7)$, $T_c(s_7)$, $T_v(s_8)$, $T_c(s_8)$, $T_v(s_9)$, $T_c(s_9)$, $T_v(s_{10})$, $T_c(s_{10})$.

Si on s'intéresse aux états possibles du signal $s_1$, pour deux états logiques B et H possibles de chacun des signaux $s_5$ à $s_{10}$, la troisième étape est exécutée où chacun des diagrammes de décision binaire $T_c(s_5)$, $T_c(s_6)$, $T_c(s_7)$, $T_c(s_8)$, $T_c(s_9)$, $T_c(s_{10})$ vaut 1 et où chacun des diagrammes de décision binaire $T_v(s_5)$, $T_v(s_6)$, $T_v(s_7)$, $T_v(s_8)$, $T_v(s_9)$, $T_v(s_{10})$, est remplacé respectivement par chacun des diagrammes de décision binaire $\{x_{v5};0;1\}$, $\{x_{v6};0;1\}$, $\{x_{v7};0;1\}$, $\{x_{v8};0;1\}$, $\{x_{v9};0;1\}$, $\{x_{v10};0;1\}$. On obtient ainsi trois diagrammes de décision binaire $T_v(s_1)$, $T_c(s_1)$, $T_e(s_1)$ avec des noeuds occupés par les variables $x_{v5}$, $x_{v6}$, $x_{v7}$, $x_{v8}$, $x_{v9}$, $x_{v10}$ et des feuilles à 0 ou à 1.

Pour connaître par exemple les valeurs de $x_{v5}$, $x_{v6}$, $x_{v7}$, $x_{v8}$, $x_{v9}$, $x_{v10}$ qui mettent le signal $s_1$ à l'état logique H, un diagramme de décision binaire $T_1(s_1)$ est construit au moyen de la règle R1:

$$T1(s1) = Tv(s1) \cdot Tc(s1) \cdot \overline{Te(s1)}$$

Le diagramme de décision binaire $T_1(s_1)$ est parcouru sur chaque branche conduisant du noeud occupé par la variable $x_{v5}$, à une feuille occupée par la valeur 1, en conservant dans une conjonction logique chaque variable $x_{v5}$, $x_{v6}$, $x_{v7}$, $x_{v8}$, $x_{v9}$, $x_{v10}$ rencontrée telle quelle si le parcours de la branche est poursuivi au moyen du pointeur droit et complémentée si le parcours de la branche est poursuivi au moyen du pointeur gauche. Chaque conjonction logique obtenue par le parcours sur une branche, est conservée dans une disjonction logique jusqu'à avoir parcouru toutes les branches conduisant à une feuille occupée par la valeur 1. On obtient ainsi une équation logique du circuit de la figure 3:

$$s1=$$

$$+s5 \cdot s6 \cdot s7 \cdot s8 \cdot \overline{s9} \cdot s10 + s5 \cdot s6 \cdot s7 \cdot s8 \cdot s9 + s5 \cdot s6 \cdot \overline{s7} \cdot \overline{s9} \cdot s10$$

$$+\overline{s5} \cdot s7 \cdot s8 \cdot s9 + \overline{s5} \cdot s7 \cdot s8 \cdot \overline{s9} \cdot s10 + \overline{s5} \cdot \overline{s7} \cdot \overline{s9} \cdot s10 + s5.s6.s7.\overline{s9}$$

Appliquons par exemple le procédé précédemment décrit au circuit élémentaire de la figure 4 où cinq signaux d'entrée $s_{16}$, $s_{17}$, $s_{18}$, $s_{19}$, $s_{21}$, se combinent pour générer un signal $s_{12}$.

L'entité élémentaire de circuit de la figure 4 comprend deux transistors NMOS 34 et 35, dont les sources sont respectivement attaquées par les signaux $s_{16}$ et $s_{18}$, dont les grilles sont respectivement attaquées par les signaux $s_{17}$ et $s_{19}$, et dont les drains génèrent respectivement des signaux $s_{13}$ et $s_{14}$ sur des conducteurs 29 et 30. L'entité élémentaire de circuit de la figure 4 comprend aussi deux transistors PMOS 37 et 36, dont les sources sont respectivement attaquées par le signal $s_{21}$ et un signal $s_{20}$, dont les grilles sont respectivement attaquées par les signaux $s_{17}$ et $s_{19}$, et dont les drains génèrent respectivement le signal $s_{20}$ et un signal $s_{15}$ sur des conducteurs 32 et 31. Les conducteurs 29, 30 et 31 sont raccordés à un conducteur 28 en un point 33.

La cinquième étape scrute (scan en anglais) chacun des signaux $s_{16}$, $s_{17}$, $s_{18}$, $s_{19}$, $s_{21}$, de la liste de connectique et pour chaque signal scruté, exécute les deux premières étapes.

Dans le cas où les sources des transistors 34 et 35 sont reliées à la masse, les diagrammes de décision binaire $T_v(s_{16})$, $T_c(s_{16})$, $T_e(s_{16})$, $T_v(s_{18})$, $T_c(s_{18})$, $T_e(s_{18})$ sont respectivement égaux aux singletons {0}, {1}, {0}, {0}, {1}, {0}. Dans le cas où la source du transistor 37 est reliée à l'alimentation, les diagrammes de décision binaire $T_v(s_{21})$, $T_c(s_{21})$, $T_e(s_{21})$, sont respectivement égaux aux singletons {1}, {1}, {0}. Dans le cas où les grilles des transistors 34 et 37 sont reliés à une entrée nécessairement mises à un état logique 0 ou 1, les diagrammes de décision binaire $T_v(s_{17})$, $T_c(s_{17})$, $T_e(s_{17})$, sont respectivement {$x_{v17}$,0,1}, {1}, {0}. Dans le cas où les grilles des transistors 35 et 36 sont reliés à une entrée nécessairement mises à un état logique B ou H, les diagrammes de décision binaire $T_v(s_{19})$, $T_c(s_{19})$, $T_e(s_{19})$, sont respectivement {$x_{v19}$,0,1}, {1}, {0}.

Les éléments du circuit élémentaire attaqués par les signaux $s_{16}$, $s_{17}$, $s_{18}$, $s_{19}$, $s_{21}$, de la liste de connectique, sont ensuite scrutés de façon à associer aux transistors 34, 35, 37, respectivement les signaux $s_{13}$, $s_{14}$, $s_{20}$, pour chacun desquels les étapes 1 à 5 sont exécutées.

Pour le transistor 34, les règles Rvn, Rcn, Ren s'appliquent au signal $s_{13}$, dans la deuxième étape.

$$Tv(s13) = Tc(s17) \cdot Tv(s17) \cdot Tv(s16) + Tc(s17) \cdot \overline{Tv(s17)}$$

$$Tc(s13) = Tc(s17) \cdot Tv(s17) \cdot Tc(s16)$$

$$Te(s13) = Tv(s17) - \overline{Tc(s17)}$$

Ce qui donne en appliquant les règles de combinaison connues de diagrammes de décision binaire:

$$T_v(s_{13}) = \{x_{v17},1,0\}$$

$$T_c(s_{13}) = \{x_{v17},0,1\}$$

$$T_e(s_{13}) = \{0\}$$

Pour le transistor 35, les règles Rvn, Rcn, Ren s'appliquent au signal $s_{14}$, dans la deuxième étape pour donner de façon identique:

$$T_v(s_{14}) = \{x_{v19},1,0\}$$

$$T_c(s_{14}) = \{x_{v19},0,1\}$$

$$T_e(s_{14}) = \{0\}$$

Pour le transistor 37, les règles Rvp, Rcp, Rep s'appliquent au signal $s_{20}$, dans la deuxième étape.

$$Tv(s20) = Tc(s17)\cdot\overline{Tv(s17)}\cdot Tv(s21) + Tc(s17)\cdot Tv(s17)$$

$$Tc(s20) = Tc(s17)\cdot\overline{Tv(s17)}\cdot Tc(s21)$$

$$Te(s20) = Tv(s17)\cdot\overline{Tc(s17)}$$

Ce qui donne en appliquant les règles de combinaison connues de diagrammes de décision binaire:

$$T_v(s_{20}) = \{1\}$$

$$T_c(s_{20}) = \{x_{v17},1,0\}$$

$$T_e(s_{20}) = \{0\}$$

La sixième étape est relancée pour scruter les éléments du circuit élémentaire attaqués par les signaux précédemment générés $s_{13}$, $s_{14}$, $s_{20}$, de la liste de connectique et associe à ces éléments qui sont le point 33 et le transistor 36, respectivement les signaux $s_{22}$, $s_{15}$, pour chacun desquels elle exécute les deux premières étapes.
Pour le point 33, les règles Rvr, Rcr, Rer s'appliquent au signal $s_{22}$, dans la deuxième étape.

$$Tv(s_{22}) = Tv(s_{13})\cdot Tv(s_{14})$$

$$\begin{aligned}
Tc(s22) = \\
+ Tc(s13)\cdot\left[\overline{Tc(s14)} + \overline{Tv(s13)}\cdot\overline{Tv(s14)} + Tv(s13)\cdot Tv(s14)\right] \\
+ Tc(s14)\cdot\left[\overline{Tc(s13)} + \overline{Tv(s13)}\cdot\overline{Tv(s14)} + Tv(s13)\cdot Tv(s14)\right]
\end{aligned}$$

$$Te(s22) = Tc(s13)\cdot Tc(s14)\cdot\left[Tv(s13)\cdot\overline{Tv(s14)} + \overline{Tv(s13)}\cdot Tv(s14)\right]$$

Ce qui donne en appliquant les règles de combinaison connues de diagrammes de décision binaire:

$$T_v(s_{22}) = \{x_{v17},\{x_{v19},\,1,0\},0\}$$

$$T_c(s_{22}) = \{x_{v17},\{x_{v19},0,1\},1\}$$

$$T_e(s_{22}) = \{x_{v17},0,\{x_{v19},0,0\}\}=\{0\}$$

Pour le transistor 36, les règles Rvp, Rcp, Rep s'appliquent au signal $s_{15}$, dans la deuxième étape.

$$Tv(s15) = \left[ Tc(s19) \cdot \overline{Tv(s19)} \cdot Tv(s20) + Tc(s19) \cdot Tv(s19) \right]$$

$$Tc(s15) = Tc(s19) \cdot \overline{Tv(s19)} \cdot Tc(s20)$$

$$Te(s15) = Tv(s19) \cdot \overline{Tc(s19)}$$

Ce qui donne en appliquant les règles de combinaison connues de diagrammes de décision binaire:

$$T_v(s_{15}) = \{1\}$$

$$T_c(s_{15}) = \{xv_{17}, \{x_{v19}, 1, 0\}, 0\}$$

$$T_e(s_{15}) = \{0\}$$

La sixième étape est relancée pour scruter les éléments du circuit élémentaire attaqués par les signaux précédemment générés $s_{22}$, $s_{15}$, de la liste de connectique et associe au seul élément trouvé qui est le point 33, le signal $s_{12}$ pour lequel elle exécute les deux premières étapes.

Pour le point 33, les règles Rvr, Rcr, Rer s'appliquent au signal $s_{12}$, dans la deuxième étape.

$$Tv(s_{12}) = Tv(s_{22}) - Tv(s_{15})$$

$$\begin{aligned} Tc(s12) = \\ + Tc(s22) \cdot \left[ \overline{Tc(s15)} + \overline{Tv(s22)} \cdot \overline{Tv(s15)} + Tv(s22) \cdot Tv(s15) \right] \\ + Tc(s15) \cdot \left[ \overline{Tc(s22)} + \overline{Tv(s22)} \cdot \overline{Tv(s15)} + Tv(s22) \cdot Tv(s15) \right] \end{aligned}$$

$$Te(s12) = Tc(s22) \cdot Tc(s15) \cdot \left[ Tv(s22) \cdot \overline{Tv(s15)} + \overline{Tv(s22)} \cdot Tv(s15) \right]$$

Ce qui donne en appliquant les règles de combinaison connues de diagrammes de décision binaire:

$$T_v(s_{12}) = \{x_{v17}, \{x_{v19}, 1, 0\}, 0\}$$

$$T_c(s_{12}) = \{x_{v17}, 1, \{x_{v19}, 1, 1\}\} = \{1\}$$

$$T_e(s_{12}) = \{x_{v17}, 0, \{x_{v19}, 0, 0\}\} = \{0\}$$

Le seul signal restant étant le signal $s_{12}$, la quatrième étape donne le diagramme de décision binaire $T_{log}(s_{12})$ au moyen de la règle Rlog:

$$T_{log}(s_{12}) = T_v(s_{12}) \cdot T_o(s_{12})$$

$$= \{x_{v17}, \{x_{v19}, 1, 0\}, 0\}$$

La variable binaire $x_{v12}$ est à l'état logique 1 pour les branches du diagramme de décision binaire $T_{log}(s_{12})$ qui mènent à 1. Ce qui s'écrit

$$xv12 = \overline{xv17} \cdot \overline{xv19}$$

Dans la quatrième étape, le circuit de la figure 4 est reconnu comme étant une porte NOR.

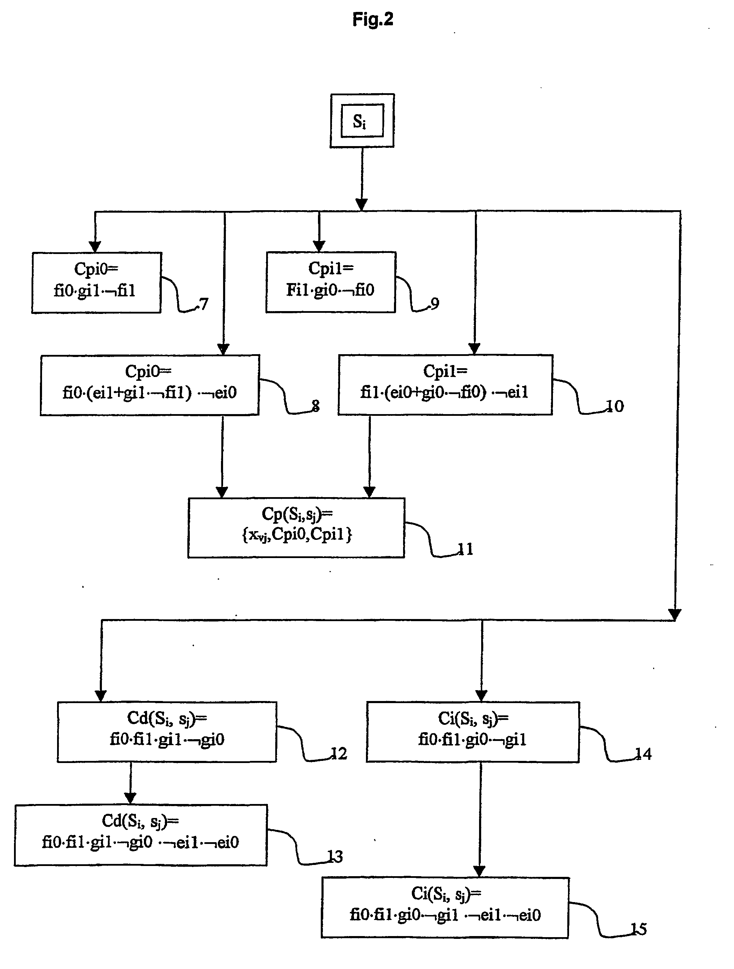

La figure 2 représente des étapes de procédé pour indiquer, en rapport avec un élément physique générant un premier signal (s11) en fonction d'un deuxième signal (s5) et de troisièmes signaux (s6,s7,s8), une combinaison d'états des dits troisièmes signaux telle qu'un changement d'état du dit deuxième signal fait passer ledit premier signal d'un état binaire à un état non binaire.

A un signal $s_i$ sont associés deux ou trois diagrammes de décision binaire $T_c(s_i) = \{x_{vj}, fi0, fi1\}$, $T_v(s_i) = \{x_{vj}, gi0, gi1\}$, $T_e(s_i) = \{x_{vj}, ei0, ei1\}$, où fi0, gi0, ei0, sont des pointeurs sur des sous diagrammes de décision binaire lorsque $x_{vj}$ est égal à 0, où fi1, gi1, ei1, sont des pointeurs sur des sous diagrammes de décision binaire lorsque $x_{vj}$ est égal à 1, $x_{cj}$ étant pris dans tous les cas égal à 1 car on ne considère ici que les états binaires B,H du signal $s_j$ auquel est associé la variable $x_{vj}$. Pour simplifier, ces pointeurs seront assimilés aux sous diagrammes de décision binaires qu'ils pointent. Le procédé décrit reste valable pour tout signal $s_k$ auquel est associé une variable $x_{vk}$ en réordonnant de façon connue les diagrammes de décision binaire de façon à faire remonter $x_{vk}$ à la racine du diagramme de décision binaire.

Les valeurs à 1 du sous diagramme de décision binaire fi0 codent des combinaisons de variables $x_{vn}$ pour lesquelles la variable $x_{ci}$ a pour valeur 1, c'est à dire le signal $s_i$ est à l'un des états binaires B ou H, lorsque la variable $x_{vj}$ a pour valeur 0.

Les valeurs à 1 du sous diagramme de décision binaire fi1 codent des combinaisons de variables $x_{vn}$ pour lesquelles la variable $x_{ci}$ a pour valeur 1, c'est à dire le signal $s_i$ est à l'un des états binaires B ou H, lorsque la variable $x_{vj}$ a pour valeur 1.

Les valeurs à 1 du sous diagramme de décision binaire gi0 codent des combinaisons de variables $x_{vn}$ pour lesquelles la variable $x_{vi}$ a pour valeur 1, c'est à dire le signal $s_i$ est à l'état binaire H ou à l'état non binaire Z, lorsque la variable $x_{vj}$ a pour valeur 0.

Les valeurs à 1 du sous diagramme de décision binaire gi1 codent des combinaisons de variables $x_{vn}$ pour lesquelles la variable $x_{vi}$ a pour valeur 1, c'est à dire le signal $s_i$ est à l'état binaire H ou à l'état non binaire Z, lorsque la variable $x_{vj}$ a pour valeur 1.

Les valeurs à 1 du sous diagramme de décision binaire ei0 codent des combinaisons de variables $x_{vn}$ pour lesquelles les variables $x_{ci}, x_{vi}$ ont pour valeur 0, c'est à dire le signal $s_i$ est à un état indéterminé tel que l'état non binaire E, lorsque la variable $x_{vj}$ a pour valeur 0.

Les valeurs à 1 du sous diagramme de décision binaire ei0 codent des combinaisons de variables $x_{vn}$ pour lesquelles les variables $x_{ci}, x_{vi}$ ont pour valeur 0, c'est à dire le signal $s_i$ est à un état indéterminé tel que l'état non binaire E, lorsque la variable $x_{vj}$ a pour valeur 1.

Dans la suite de la description, le symbole $\neg$ placé devant une référence de diagramme de décision binaire signifie que le diagramme de décision binaire est comptémenté de façon connue selon ce qui précède.

Une étape 8 génère un sous diagramme de décision binaire Cpi0 en combinant les sous diagrammes de décision binaire ci-dessus mentionnés au moyen de la formule :

$$Cpi0 = fi0 \cdot \neg ei0 \cdot (ei1 + gi1 \cdot \neg fi1).$$

La combinaison $gi1 \cdot \neg fi1$ code des combinaisons de variables $x_{vn}$ pour lesquelles la variable $x_{vi}$ a pour valeur 1, c'est à dire le signal $s_i$ est à l'état binaire H ou à l'état non binaire Z, et pour lesquelles la variable $x_{ci}$ n'a pas pour valeur 1, c'est à dire le signal $s_i$ n'est pas à l'un des états binaires B ou H, lorsque la variable $x_{vj}$ a pour valeur 1. La disjonction de cette combinaison avec ei1 code ainsi les combinaisons de variables $x_{vn}$ pour lesquelles le signal $s_i$ n'est pas à l'un des états binaires B ou H, lorsque la variable $x_{vj}$ a pour valeur 1. La combinaison $fi0 \cdot \neg ei0$ code des combinaisons de variables $x_{vn}$ pour lesquelles la variable $x_{vi}$ a pour valeur 1, c'est à dire le signal $s_i$ est à l'état binaire H ou à l'état non binaire Z, et pour lesquelles la variable $x_{ci}$ n'a pas pour valeur 0, c'est à dire le signal $s_i$ n'est pas à un état non binaire, lorsque la variable $x_{vj}$ a pour valeur 0. La disjonction de cette dernière combinaison avec ei1 code ainsi les combinaisons de variables $x_{vn}$ pour lesquelles le signal $s_i$ est à l'un des états binaires B ou H, lorsque la variable $x_{vj}$ a pour valeur 0, et n'est pas à l'un des états binaires B ou H, lorsque la variable $x_{vj}$ a pour valeur 1.

Les valeurs à 1 de Cpi0 correspondent à un ensemble de combinaisons de valeurs $x_{vn}$ pour lesquelles $s_i$ est à un état binaire lorsque $x_{vj}$ n'est pas à la valeur 1, et pour lesquelles $s_i$ n'est pas à un état binaire lorsque $x_{vj}$ est à la valeur 1.

Ainsi, pour les combinaisons à 1 des variables $x_{vn}$, le signal $s_i$ passe d'un état binaire à un état non binaire lorsque le signai $s_j$ passe du premier état B au deuxième état H.

Lorsque l'élément physique est tel que l'état du signal $s_i$ n'est jamais indéterminé, le sous diagrammes de décision binaire e11 est toujours à 0 et le sous diagramme de décision binaire ¬e10 est toujours à 1. Ces sous diagrammes de décision binaire n'ont pas à être pris en considération dans une étape 7 qui se contente alors de la formule simplifiée suivante pour générer le sous diagramme de décision binaire Cp10 :

$$Cpi0 = fi0 \cdot gi1 \cdot \neg fi1).$$

Une étape 10 génère un sous diagramme de décision binaire Cpi1 en combinant les sous diagrammes de décision binaire ci-dessus mentionnés au moyen de la formule:

$$Cpi1 = fi1 \cdot \neg ei1 \cdot (ei0 + gi0 \cdot \neg fi0).$$

La combinaison gi0.¬fi0 code des combinaisons de variables $x_{vn}$ pour lesquelles la variable $x_{vi}$ a pour valeur 1, c'est à dire le signal $s_i$ est à l'état binaire H ou à l'état non binaire Z, et pour lesquelles la variable $x_{ci}$ n'a pas pour valeur 1, c'est à dire le signal $s_i$ n'est pas à l'un des états binaires B ou H, lorsque la variable $x_{vj}$ a pour valeur 0. La disjonction de cette combinaison avec ei0 code ainsi les combinaisons de variables $x_{vn}$ pour lesquelles le signal $s_i$ n'est pas à l'un des états binaires B ou H, lorsque la variable $x_{vj}$ a pour valeur 0. La combinaison fi1·¬ei1 code des combinaisons de variables $x_{vn}$ pour lesquelles la variable $x_{vi}$ a pour valeur 1, c'est à dire le signal $s_i$ est à l'état binaire H ou à l'état non binaire Z, et pour lesquelles la variable $x_{ci}$ n'a pas pour valeur 0, c'est à dire le signal $s_i$ n'est pas à un état non binaire, lorsque la variable $x_{vi}$ a pour valeur 1. La disjonction de cette demière combinaison avec ei0 code ainsi les combinaisons de variables $x_{vn}$ pour lesquelles le signal $s_i$ est à l'un des états binaires B ou H, lorsque la variable $x_{vj}$ a pour valeur 1, et n'est pas à l'un des états binaires B ou H, lorsque la variable $x_{vj}$ a pour valeur 0.

Les valeurs à 1 de Cpi1 correspondent à un ensemble de combinaisons de valeurs $x_{vn}$ pour lesquelles $s_i$ est à un état binaire lorsque $x_{vj}$ n'est pas à la valeur 0, et pour lesquelles $s_i$ n'est pas à un état binaire lorsque $x_{vj}$ est à la valeur 0.

Ainsi, pour les combinaisons à 1 des variables $x_{vn}$, le signal $s_i$ passe d'un état binaire à un état non binaire lorsque le signal $s_j$ passe du deuxième état H au premier état B.

Lorsque l'élément physique est tel que l'état du signal $s_i$ n'est jamais indéterminé, le sous diagrammes de décision binaire e11 est toujours à 0 et le sous diagramme de décision binaire ¬e10 est toujours à 1. Ces sous diagrammes de décision binaire n'ont pas à être pris en considération dans une étape 9 qui se contente alors de la formule simplifiée suivante pour générer le sous diagramme de décision binaire Cpi1 :

$$Cpi1 = fi1 \cdot gi0 \cdot \neg fi0).$$

Une étape 11 génère un diagramme de décision binaire Cp(Si,sj) avec à sa racine, la variable xvj, une branche gauche égale au sous diagramme Cpi0 et une branche droite égale au sous diagramme Cpi1. Les valeurs à 1 de ce diagramme de décision binaire code les combinaisons de signaux sn pour lesquelles un changement d'état binaire du signal $s_j$ fait passer le signal $s_i$ d'un état binaire à un état non binaire.

Une étape 13 génère un sous diagramme de décision binaire Cdi0 en combinant les sous diagrammes de décision binaire ci-dessus mentionnés au moyen de la formule :

$$Cdi0 = fi0 \cdot \neg gi0 \cdot \neg ei0 \cdot fi1 \cdot gi1 \cdot \neg ei1.$$

La combinaison gi1·fi1· code, des combinaisons de variables $x_{vn}$ pour lesquelles la variable $x_{vi}$ a pour valeur 1, c'est à dire le signal $s_i$ est à l'état binaire H ou à l'état non binaire Z, et pour lesquelles la variable $x_{ci}$ a pour valeur 1, c'est à dire le signal $s_i$ est à l'état binaire H, lorsque la variable $x_{vj}$ a pour valeur 1. La conjonction de cette combinaison avec ¬ei1 code ainsi les combinaisons de variables $x_{vn}$ pour lesquelles le signal $s_i$ est à l'état binaire H, lorsque la variable $x_{vj}$ a pour valeur 1. La combinaison fi0·¬ei0 code des combinaisons de variables $x_{vn}$ pour lesquelles la variable $x_{vi}$ a pour valeur 1, c'est à dire le signal $s_i$ est à l'état binaire H ou à l'état binaire B, et pour lesquelles la variable $x_{ci}$

n'a pas pour valeur 0, c'est à dire le signal $s_i$ n'est pas à un état non binaire, lorsque la variable $x_{vj}$ a pour valeur 0. La conjonction de cette dernière combinaison avec $\neg gi0$ code ainsi les combinaisons de variables $x_{vn}$ pour lesquelles le signal $s_i$ est à l'état binaire B, lorsque la variable $x_{vj}$ a pour valeur 0, et n'est pas à un état non binaire, lorsque la variable $x_{vj}$ a pour valeur 0.

Les valeurs à 1 de Cdi0 correspondent à un ensemble de combinaisons de valeurs $x_{vn}$ pour lesquelles $s_i$ est à un état binaire B lorsque $x_{vj}$ est à la valeur 0, et pour lesquelles $s_i$ est à un état binaire H lorsque $x_{vj}$ est à la valeur 1.

Ainsi, pour les combinaisons à 1 des variables $x_{vn}$, le signal $s_i$ passe d'un état binaire B à un état binaire H lorsque le signal $s_j$ passe du premier état B au deuxième état H. Par symétrie, le signal $s_i$ passe d'un état binaire H à un état binaire B lorsque le signal $s_j$ passe du premier état B au deuxième état H.

Lorsque l'élément physique est tel que l'état du signal $s_i$ n'est jamais indéterminé, le sous diagrammes de décision binaire e11 est toujours à 0 et le sous diagramme de décision binaire $\neg e10$ est toujours à 1. Ces sous diagrammes de décision binaire n'ont pas à être pris en considération dans une étape 12 qui se contente alors de la formule simplifiée suivante pour générer le sous diagramme de décision binaire Cdi0 :

$$Cdi0 = fi0 \cdot \neg gi0 \cdot fi1 \cdot gi1 \cdot .$$

Une étape 15 génère un diagramme de décision binaire $Cii(s_i, s_j)$ en combinant les sous diagrammes de décision binaire ci-dessus mentionnés au moyen de la formule :

$$Cii(s_i, s_j) = fi0 \cdot \neg gi1 \cdot ei0 \cdot fi1 \cdot gi0 \cdot \neg ei1.$$

La combinaison $gi0 \cdot fi0$ code des combinaisons de variables $x_{vn}$ pour lesquelles la variable $x_{vi}$ a pour valeur 1, c'est à dire le signal $s_i$ est à l'état binaire H lorsque la variable $x_{vj}$ a pour valeur 0. La conjonction de cette combinaison avec $\neg ei1$ code ainsi les combinaisons de variables $x_{vn}$ pour lesquelles le signal $s_i$ n'est pas à un état indéterminé, lorsque la variable $x_{vj}$ n'a pas pour valeur 0. La combinaison $fi1 \cdot \neg gi1$ code des combinaisons de variables $x_{vn}$ pour lesquelles la variable $x_{vi}$ a pour valeur 0, c'est à dire le signal $s_i$ est à l'état binaire B, lorsque la variable $x_{vj}$ a pour valeur 1. La conjonction de cette dernière combinaison avec $\neg ei0$ code ainsi les combinaisons de variables $x_{vn}$ pour lesquelles le signai $s_i$ n'est pas à un état indéterminé, lorsque la variable $x_{vj}$ n'a pas pour valeur 1.

Les valeurs à 1 de $Cii(s_i, s_j)$ correspondent à un ensemble de combinaisons de valeurs $x_{vn}$ pour lesquelles $s_i$ est à un état binaire H lorsque $x_{vj}$ est à la valeur 0, et pour lesquelles $s_i$ est à un état binaire B lorsque $x_{vj}$ est à la valeur 1.

Ainsi, pour les combinaisons à 1 des variables $x_{vn}$, le signal $s_i$ passe d'un état binaire H à un état binaire B lorsque le signal $s_j$ passe du premier état B au deuxième état H. Par symétrie, le signal $s_i$ passe d'un état binaire B à un état binaire H lorsque le signal $s_j$ passe du deuxième état H au premier état B.

Lorsque l'élément physique est tel que l'état du signal $s_i$ n'est jamais indéterminé, le sous diagrammes de décision binaire e11 est toujours à 0 et le sous diagramme de décision binaire $\neg e10$ est toujours à 1. Ces sous diagrammes de décision binaire n'ont pas à être pris en considération dans une étape 14 qui se contente alors de la formule simplifiée suivante pour générer le sous diagramme de décision binaire $Cii(s_i, s_j)$:

$$Cii(s_i, s_j) = fi0 \cdot \neg gi1 \cdot fi1 \cdot gi0.$$

Les étapes 7 à 15 ont en commun de générer un diagramme de décision binaire dont les valeurs à 1 correspondent à un premier état du signal $s_i$ lorsque $x_{vj}$ est à une première valeur et à un deuxième état différent lorsque $x_{vj}$ n'est pas à la première valeur.

En reprenant le circuit élémentaire de la figure 3, les trois diagrammes de décision binaire sont déployés récursivement à partir chacun des diagrammes de décision binaire $T_c(s_5)$, $T_c(s_6)$, $T_c(s_7)$, $T_c(s_8)$, $T_c(s_9)$, $T_c(s_{10})$ valant 1 et de chacun des diagrammes de décision binaire $T_v(s_5)$, $T_v(s_6)$, $T_v(s_7)$, $T_v(s_8)$, $T_v(s_9)$, $T_v(s_{10})$, remplacé respectivement par chacun des diagrammes de décision binaire $\{x_{v5};0;1\}$, $\{x_{v6};0;1\}$, $\{x_{v7};0;1\}$, $\{x_{v8};0;1\}$, $\{x_{v9};0;1\}$, $\{x_{v10};0;1\}$. On obtient ainsi en prenant un ordre alphanumérique :

Pour s4 :

$$Tv(s4) = \left[ Tc(s9) \cdot \overline{Tv(s9)} \cdot Tv(s10) + Tc(s9) \cdot Tv(s9) \right]$$

$$Tv(s_4)=\{x_{v9};\{x_{v10};0;1\};0\}+\{x_{v9};0;1\}$$

$$Tv(s_4)=\{x_{v9};\{x_{v10};0;1\};1\}$$

$$Tc(s4) = Tc(s9)\cdot \overline{Tv(s9)}\cdot Tc(s10)$$

$$Tc(s_4)=\{x_{v9};1;0\}$$

$$Te(s_4)=\{0\}$$

Pour s3 :

$$Tv(s3) = \left[Tc(s7)\cdot Tv(s7)\cdot Tv(s8)+Tc(s7)\cdot \overline{Tv(s7)}\right]$$

$$Tv(s_3)=\{x_{v7};0;\{x_{v8};0;1\}\}+\{x_{v7};1;0\}$$

$$Tv(s_3)= \{x_{v7};1;\{x_{v8};0;1\}\}$$

$$Tc(s3) = Tc(s7)\cdot Tv(s7)\cdot Tc(s8)$$

$$Tc(s_3)= \{x_{v7};0;1\}$$

$$Te(s_3)=\{0\}$$

Pour s2 :

$$Tv(s_2)= \{x_{v5};1;\{x_{v6};0;1\}\}$$

$$Tc(s_2)= \{x_{v5};0;1\}$$

$$Te(s_2)=\{0\}$$

Pour s11 :

$$Tc(s11) =$$
$$+ Tc(s2)\cdot \left[\overline{Tc(s3)}+\overline{Tv(s2)}\cdot \overline{Tv(s3)}+Tv(s2)\cdot Tv(s3)\right]$$
$$+ Tc(s3)\cdot \left[\overline{Tc(s2)}+\overline{Tv(s2)}\cdot \overline{Tv(s3)}+Tv(s2)\cdot Tv(s3)\right]$$

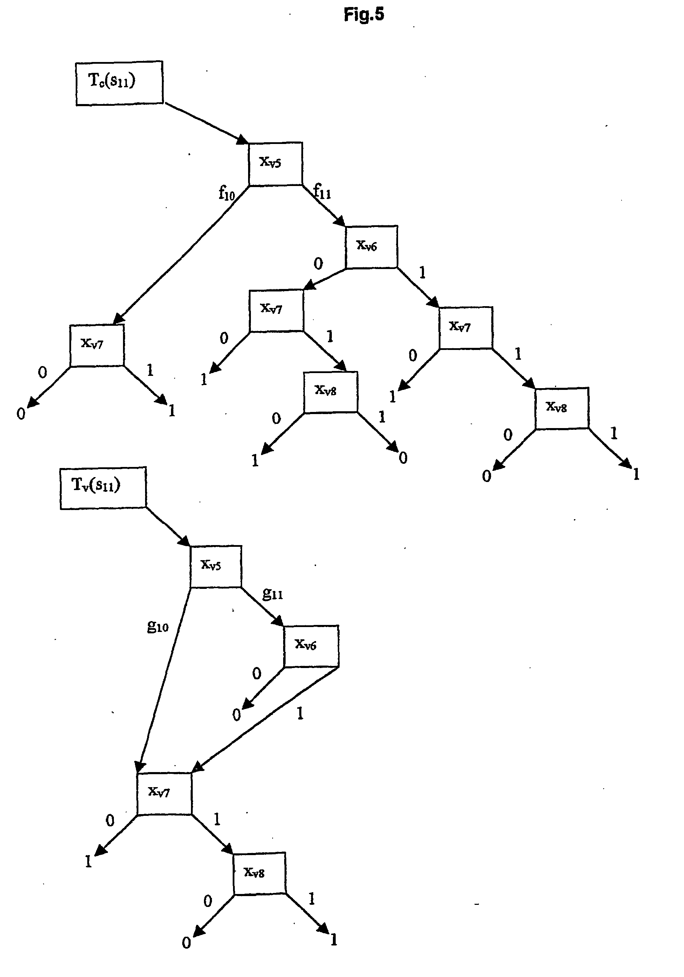

Les règles de combinaison des diagrammes de décision binaire donnent le diagramme de décision binaire Tc(s11)représenté figure 5, à savoir un triplet $\{x_{v5};f_{10};f_{11}\}$

Où $f_{10}$ est un pointeur sur un sous diagramme de décision binaire $\{x_{v7};0;1\}$ et où $f_{11}$ est un pointeur sur un sous diagramme de décision binaire

$\{x_{v6};\{x_{v7};1;\{x_{v8};1;0\}\};\{x_{v7};1;\{x_{v8};0;1\}\}\}$.

$$T_v(s_{11})= T_v(s_2)\cdot T_v(s_3)$$

Les règles de combinaison des diagrammes de décision binaire donnent le diagramme de décision binaire Tv(s11) représenté figure 5, à savoir un triplet $\{x_{v5};g_{10};g_{11}\}$

Où $g_{10}$ est un pointeur sur un sous diagramme de décision binaire $\{x_{v7};1;\{x_{v8};0;1\}\}$et où $g_{11}$ est un pointeur sur un sous diagramme de décision binaire $\{x_{v6};0;\{x_{v7};1;\{x_{v8};0;1\}\}\}$.

$$\mathrm{Te}(s11) = \mathrm{Tc}(s2) \cdot \mathrm{Tc}(s3) \cdot \left[\mathrm{Tv}(s2) \cdot \overline{\mathrm{Tv}(s3)} + \overline{\mathrm{Tv}(s2)} \cdot \mathrm{Tv}(s3)\right] + \mathrm{Te}(s2) + \mathrm{Te}(s3)$$

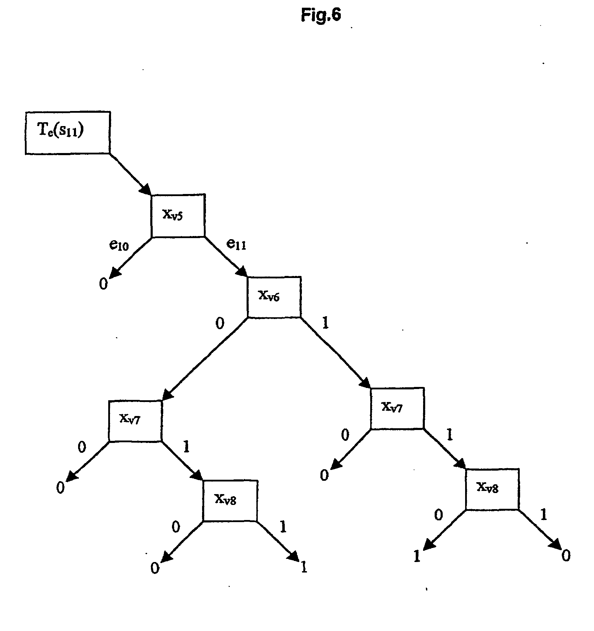

Les règles de combinaison des diagrammes de décision binaire donnent le diagramme de décision binaire Te(s11)représenté figure 6, à savoir un triplet $\{x_{v5};e_{10};e_{11}\}$

Où $e_{10}$ est un pointeur sur un sous diagramme de décision binaire $\{0\}$ et où $e_{11}$ est un pointeur sur un sous diagramme de décision binaire $\{x_{v6};\{x_{v7};0;\{x_{v8};0;1\}\};\{x_{v7};0;\{x_{v8};1;0\}\}\}$.

Le diagramme de décision binaire Cp(S11,S5)= $\{x_{v5};cp_{10};cp_{11}\}$est généré en étape 11 avec:

$$cp10 = f10\cdot \overline{e10}\cdot \left(e11+ \overline{f11}\cdot g11\right)$$

En appliquant les règles de combinaison des diagrammes de décision binaire, cp10 pointe sur un sous diagramme de décision binaire $\{x_{v6};\{x_{v7};0;\{x_{v8};0;1\}\};\{x_{v7};0;\{x_{v8};1;0\}\}\}\}$.

$$cp11 = f11\cdot \overline{e11}\cdot \left(e10+ \overline{f10}\cdot g10\right)$$

En appliquant les règles de combinaison des diagrammes de décision binaire, cp11 pointe sur un sous diagramme de décision binaire $\{x_{v6};\{x_{v7};1;\{x_{v8};1;0\}\};0\}$.

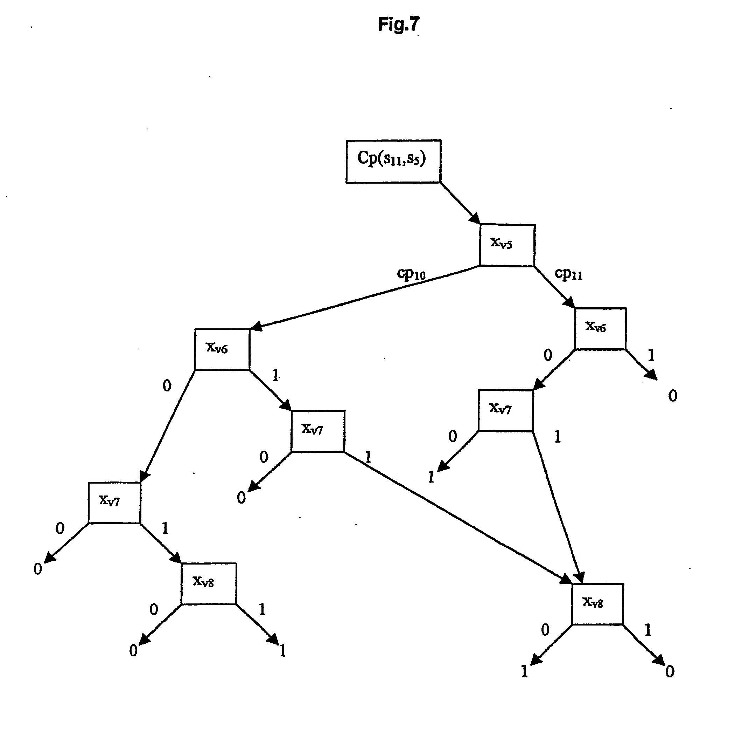

D'où le diagramme de décision binaire Cp(S11,S5) représenté figure 7.

Un parcours des branches du diagramme de décision binaire Cp(S11,S5) qui mènent à la valeur 1, donne les combinaisons de variables logiques suivantes :

-   pour $x_{v5}$ initialement égale à zéro :

$$\overline{xv6}\cdot xv7\cdot xv8 + xv6\cdot xv7\cdot \overline{xv8} = 1$$

-   pour $x_{v5}$ initialement égale à un :

$$\overline{xv6}\cdot \overline{xv7} + \overline{xv6}\cdot xv7\cdot \overline{xv8} = 1$$

Lorsqu'on applique un état binaire à chacun des signaux s5, s6, s7, s8, les variables $x_{c5}$ $x_{c6}$ $x_{c7}$ $X_{c8}$ ont toutes pour valeur 1 et les valeurs à 0, respectivement à 1, des variables $x_{v5}$ $x_{v6}$ $x_{v7}$ $x_{v8}$ représentent les états B, respectivement H, des signaux s5, s6, s7, s8.

La première combinaison indique que, lorsque l'ensemble de signaux {s6,s7,s8} est mis aux états {B,H,H} ou respectivement {H,H,B}, le passage du signal s5 d'un état B à H, fait passer le signal s11 d'un état binaire, en l'occurrence H ou respectivement B, à un état non binaire, en l'occurrence ici un état d'erreur.

La deuxième combinaison indique que, lorsque l'ensemble de signaux {s6,s7} est mis aux états {B,B} ou respectivement lorsque l'ensemble de signaux {s6,s7,s8} est mis aux états {B,H,B}, le passage du signal s5 d'un état H à B, fait passer le signal s11 d'un état binaire, en l'occurrence B, à un état non binaire, en l'occurrence ici un état de haute impédance ou respectivement un état d'erreur.

Les étapes 12 et 14 ou 13 et 15 du procédé décrit précédemment permettent d'obtenir pour un signal de sortie s11, un diagramme de décision binaire de contexte directe Cd(s11,s5) et un diagramme de décision binaire de contexte inverse Ci(s11,s5) pour chaque signal d'entrée s5 dont dépend le signal s11.

Un parcours de chaque branche du diagramme de décision binaire de contexte directe Cd(s11,s5) qui mène à 1 donne une conjonction logique d'états binaires de signaux s6, s7, s8... pour laquelle une variation d'état binaire du signal s5 est sensée provoquer une même variation d'état binaire du signal s11. Un parcours de chaque branche du diagramme de décision binaire de contexte inverse Ci(s11,s5) qui mène à 1 donne une conjonction logique d'états binaires de signaux s6, s7, s8... pour laquelle une variation d'état binaire du signal s5 est sensée provoquer une variation inverse d'état binaire du signal s11.

En appliquant une combinaison d'états binaires aux signaux s6, s7, s8... d'un échantillon matériel du circuit étudié, de telle sorte qu'une conjonction logique trouvée au paragraphe précédent soit à 1, une détection de comportement du signai de sortie s11 non conforme à la variation d'état binaire sensée être provoquée par un test de variation d'état binaire du signal s5, indique une faute sur cet échantillon matériel. Il convient alors de déclarer impropre à la consommation, un échantillon matériel pour lequel une faute est indiquée.

En répétant l'opération précédente avec s6, s7, s8... comme signal de test, il est possible de s'assurer d'un comportement conforme du signal s11 pour une variation d'état binaire de chacun des signaux s6, s7, s8...

De façon à réduire le nombre de signaux d'entrée à tester, le procédé comprend de façon avantageuse, les étapes supplémentaires suivantes.

Dans une étape 61, un diagramme de décision binaire S(s11,s5) est construit comme étant une disjonction logique des diagrammes de décision binaire de contexte directe Cd(s11,s5) et inverse Ci(s11,s5):

$$S(s11,s5) = Cd(s11,s5)+Ci(s11,s5)$$

Dans une étape 62, pour un signal s6, un diagramme de décision binaire S(s11,s6) est construit comme étant une disjonction logique des diagrammes de décision binaire de contexte directe Cd(s11,s6) et inverse Ci(s11,s6):

$$S(s11,s6) = Cd(s11,s6)+Ci(s11,s6)$$

pour la paire de signaux s5, s6, un diagramme de décision binaire S(s11,s5,s6) est construit comme étant une conjonction logique des diagrammes de décision binaire S(s11,s5) et S(s11,s6):

$$S(s11,s5,s6) = S(s11,s5) \cdot S(s11,s6)$$

Dans une étape 63, le diagramme de décision binaire S(s11,s5,s6) est ordonné de façon à commencer par les variables xv5, xv6. Si le diagramme de décision binaire S(s11,s5,s6) se présente sous la forme d'un diagramme de décision binaire a(xv7,xv8,...) indépendant de xv5 et xv6, les branches du diagramme de décision binaire a (xv7,xv8,...) sont parcourues dans une étape 64. La première branche qui mène à 1 donne une conjonction logique d'états binaires de signaux s7, s8... pour laquelle une variation d'état binaire du signal s5 est sensée provoquer une variation d'état binaire du signal s11 et pour laquelle une variation d'état binaire du signal s6 est sensée provoquer une variation d'état binaire du signal s11. En effet par construction de S(s11,s5,s6), la conjonction logique d'états binaires de signaux s7, s8,... ainsi trouvée, vérifie simultanément S(s11,s5) et S(s11,s6).

En appliquant une combinaison d'états binaires aux signaux s7, s8,... d'un échantillon matériel du circuit étudié, de telle sorte que la conjonction logique trouvée au paragraphe précédent soit à 1, une détection de comportement du signal de sortie s11 non conforme à la variation d'état binaire sensée être provoquée par un test de variation d'état binaire du signal s5, ou une détection de comportement du signal de sortie s11 non conforme à la variation d'état binaire sensée être provoquée par un test de variation d'état binaire du signal s6, indique une faute sur cet échantillon matériel. Il convient alors de déclarer impropre à la consommation, un échantillon matériel pour lequel une faute est indiquée.

Ainsi, un même profil d'états binaires de signaux s7, s8,... permet de tester la conformité de variation du signal s11 pour deux signaux s5 et s6. Lorsqu'un tel profil est trouvé par exécution des étapes 61 à 63, un gain de temps est procuré sur le test d'un échantillon matériel du circuit car ce même profil permet de tester la variation de deux signaux d'entrée différents.

Si le diagramme de décision binaire S(s11,s5,s6) ne se présente pas en étape 63 sous la forme d'un diagramme de décision binaire a(xv7,xv8,...) indépendant de xv5 et xv6, le signal s6 est conservé dans une liste annexe pour lui appliquer l'étape 61 où le signal s6 remplace alors le signal s5, de façon à détecter d'éventuelles fautes équivalentes avec d'autres signaux s7, s8...

Après l'étape 64, tant qu'il existe des signaux s7, s8... dont dépend le signal s11, les étapes 62 à 63 sont répétées dans lesquelles chacun des signaux s7, s8... remplace à son tour le signal s6.

Ceci permet de trouver un profil commun à tous les signaux qui vérifient positivement l'étape 63 pour un signal s5 donné. Ce profil commun permet de réduire la durée du test d'un échantillon matériel du circuit pour ces signaux d'entrée.

**Revendications**

1. Procédé pour indiquer, en rapport avec un élément physique générant un premier signal (s11) en fonction d'un deuxième signal (s5) et de troisièmes signaux (s6,s7,s8), une combinaison d'états des dits troisièmes signaux telle qu'un changement d'état du dit deuxième signal fait passer ledit premier signal d'un état binaire à un état non binaire, deux diagrammes de décision binaire (Tc(s11),Tv(s11)) étant associés au dit premier signal (s11), **caractérisé en ce qu'**il comprend :

   - le premier diagramme de décision binaire (Tc(s11)) comprenant :

      - un premier sous diagramme de décision binaire (f10) codant un premier ensemble des combinaisons d'états binaires des troisièmes signaux (s6,s7,s8) pour lesquelles le premier signal (s11) est à un premier état binaire (B) ou à un deuxième état binaire (H)lorsque le deuxième signal (s$_5$) est au premier état binaire (B),
      - un deuxième sous diagramme de décision binaire (f11) codant un deuxième ensemble des combinaisons d'états binaires des troisièmes signaux (s6,s7,s8) pour lesquelles le premier signal (s11) est au premier état binaire (B) ou au deuxième état binaire (H)lorsque le deuxième signal (s5) est au deuxième état binaire (H),

   - le deuxième diagramme de décision binaire (Tv(s11)) comprenant :

      - un troisième sous diagramme de décision binaire (g10) codant un troisième ensemble des combinaisons d'états binaires des troisièmes signaux (s6,s7,s8) pour lesquelles le premier signal (s11) est au deuxième état binaire (H) ou à un premier état non binaire (Z)lorsque le deuxième signal (s5) est au premier état binaire (B),
      - un quatrième sous diagramme de décision binaire (g11) codant un quatrième ensemble des combinaisons d'états binaires des troisièmes signaux (s6,s7,s8) pour lesquelles le premier signal (s11) est au deuxième état binaire (H) ou au premier état non binaire (Z) lorsque le deuxième signal (s5) est au deuxième état binaire (H),

   - une première étape qui effectue une première combinaison logique (f10·g11·¬f11) du premier, du deuxième et du quatrième sous diagramme de décision binaire, de façon à générer un cinquième sous diagramme de décision binaire (Cp10) qui code un cinquième ensemble de combinaisons d'états des dits troisièmes signaux pour lesquels le premier signal (s11) est à un premier état binaire (B) ou à un deuxième état binaire (H)lorsque le deuxième signal (s5) est au premier état binaire (B), le premier signal (s11) n'est pas au premier état binaire (B) ou au deuxième état binaire (H)lorsque le deuxième signal (s5) est au deuxième état binaire (H), le premier signal (s11) est au deuxième état binaire (H) ou au premier état non binaire (Z) lorsque le deuxième signal (s5) est au deuxième état binaire (H), de sorte qu'un passage du dit deuxième signal du deuxième état binaire (B) au premier état binaire (H), fait passer ledit premier signal d'un état binaire (H,B) au premier état non binaire (Z).

2. Procédé selon la revendication 1, un troisième diagramme de décision binaire (Te(s11)) étant associé au dit premier signal (s11),

   - le troisième diagramme de décision binaire (Te(s11)) comprenant :

      - un sixième sous diagramme de décision binaire (e10) codant un sixième ensemble des combinaisons d'états binaires des troisièmes signaux (s6,s7,s8) pour lesquelles le premier signal (s11) est à un deuxième état non binaire (E)lorsque le deuxième signal (s5) est au premier état binaire (B),

- un septième sous diagramme de décision binaire (e11) codant un septième ensemble des combinaisons d'états binaires des troisièmes signaux (s6,s7,s8) pour lesquelles le premier signal (s11) est à un deuxième état non binaire (E)lorsque le deuxième signal (s5) est au deuxième état binaire (H),

**caractérisé en ce qu'**il comprend :

- une deuxième étape qui effectue une deuxième combinaison logique (f10·(e11+g11·¬f11)·¬e10) du premier, du deuxième, du quatrième, du sixième et du septième sous diagramme de décision binaire, de façon à générer le cinquième sous diagramme de décision binaire (Cp10) qui code alors un huitième ensemble de combinaisons d'états des dits troisièmes signaux pour lesquels le premier signal (s11) est au deuxième état binaire (H) ou au premier état non binaire (Z) lorsque le deuxième signal (s5) est au deuxième état binaire (H) et le premier signal (s11) n'est pas au premier état binaire (B) ou au deuxième état binaire (H)lorsque le deuxième signal (s5) est au deuxième état binaire (H) ou le premier signal (s11) est au deuxième état non binaire (E) lorsque le deuxième signal (s5) est au deuxième état binaire (H), et pour lesquels le premier signal (s11) est au premier état binaire (B) ou au deuxième état binaire (H)lorsque le deuxième signal (s5) est au premier état binaire (B) et le premier signal (s11) n'est pas au deuxième état non binaire (E) lorsque le deuxième signal (s5) est au premier état binaire (B), de sorte qu'un passage du dit deuxième signal du deuxième état binaire (H) au premier état binaire (B), fait passer ledit premier signal d'un état binaire (H,B) au premier ou au deuxième état non binaire (Z,E).

3. Procédé selon l'une des revendications précédentes, **caractérisé en ce qu'**il comprend :

- une troisième étape qui effectue une troisième combinaison logique (f11·g10·¬f10) du premier, du deuxième et du troisième sous diagramme de décision binaire, de façon à générer un huitième sous diagramme de décision binaire (Cp11) qui code un neuvième ensemble de combinaisons d'états des dits troisièmes signaux pour lesquels le premier signal (s11) est à un premier état binaire (B) ou à un deuxième état binaire (H)lorsque le deuxième signal (s5) est au deuxième état binaire (H), le premier signal (s11) n'est pas au premier état binaire (B) ou au deuxième état binaire (H)lorsque le deuxième signal (s5) est au premier état binaire (B), le premier signal (s11) est au deuxième état binaire (H) ou au premier état non binaire (Z) lorsque le deuxième signal (s5) est au premier état binaire (B), de sorte qu'un passage du dit deuxième signal du premier état binaire (H) au deuxième état binaire (B), fait passer ledit premier signal d'un état binaire (H,B) au premier état non binaire (Z).

4. Procédé selon l'une des revendications précédentes, **caractérisé en ce qu'**il comprend :

- une quatrième étape qui effectue une quatrième combinaison logique (f11·(e10+g10·¬f10)·¬e11) du premier, du deuxième, du troisième, du sixième et du septième sous diagramme de décision binaire, de façon à générer le huitième sous diagramme de décision binaire (Cp11) qui code alors un dixième ensemble de combinaisons d'états des dits troisièmes signaux pour lesquels le premier signal (s11) est au deuxième état binaire (H) ou au premier état non binaire (Z) lorsque le deuxième signal (s5) est au premier état binaire (B) et le premier signal (s11) n'est pas au premier état binaire (B) ou au deuxième état binaire (H)lorsque le deuxième signal (s5) est au premier état binaire (B) ou le premier signal (s11) est au deuxième état non binaire (E) lorsque le deuxième signal (s5) est au premier état binaire (B), et pour lesquels le premier signal (s11) est au premier état binaire (B) ou au deuxième état binaire (H)lorsque le deuxième signal (s5) est au deuxième état binaire (H)et le premier signal (s11) n'est pas au deuxième état non binaire (E) lorsque le deuxième signal (s5) est au deuxième état binaire (H), de sorte qu'un passage du dit deuxième signal du premier état binaire (B) au deuxième état binaire (H), fait passer ledit premier signal d'un état binaire (H,B) au premier ou au deuxième état non binaire (Z,E).

5. Procédé selon la revendication 4 **caractérisé en ce qu'**il comprend :

- une cinquième étape qui génère un quatrième diagramme de décision binaire (Cp(s11,s5)) constitué du cinquième sous diagramme de décision binaire (Cp10) lorsque le deuxième signal s5 est au premier état binaire (B) d'une part, et du huitième sous diagramme de décision binaire (Cp11) lorsque le deuxième signal s5 est au deuxième état binaire (H) d'autre part, de sorte qu'un passage du dit deuxième signal du premier état binaire (B) au deuxième état binaire (H), respectivement du dit deuxième signal du premier état binaire (B) au deuxième état binaire (H), fait passer ledit premier signal d'un état binaire (H,B) au premier ou au deuxième état non binaire (Z,E).

**6.** Procédé pour indiquer, en rapport avec un élément physique générant un premier signal (s11) en fonction d'un deuxième signal (s5) et de troisièmes signaux (s6,s7,s8), une combinaison d'états binaires des dits troisièmes signaux telle qu'un changement d'état binaire du dit deuxième signal procure le même changement d'état binaire du dit premier signal, deux diagrammes de décision binaire (Tc(s11),Tv(s11)) étant associés au dit premier signal (s11),

**caractérisé en ce qu'**il comprend :

- le premier diagramme de décision binaire (Tc(s11)) comprenant :

    - un premier sous diagramme de décision binaire (f10) codant un premier ensemble des combinaisons d'états binaires des troisièmes signaux (s6,s7,s8) pour lesquelles le premier signal (s11) est à un premier état binaire (B) ou à un deuxième état binaire (H)lorsque le deuxième signal (s5) est au premier état binaire (B),
    - un deuxième sous diagramme de décision binaire (f11) codant un deuxième ensemble des combinaisons d'états binaires des troisièmes signaux (s6,s7,s8) pour lesquelles le premier signal (s11) est au premier état binaire (B) ou au deuxième état binaire (H)lorsque le deuxième signal (s5) est au deuxième état binaire (H),

- le deuxième diagramme de décision binaire (Tv(s11)) comprenant :

    - un troisième sous diagramme de décision binaire (g10) codant un troisième ensemble des combinaisons d'états binaires des troisièmes signaux (s6,s7,s8) pour lesquelles le premier signal (s11) est au deuxième état binaire (H) ou à un premier état non binaire (Z)lorsque le deuxième signal (s5) est au premier état binaire (B),
    - un quatrième sous diagramme de décision binaire (g11) codant un quatrième ensemble des combinaisons d'états binaires des troisièmes signaux (s6,s7,s8) pour lesquelles le premier signal (s11) est au deuxième état binaire (H) ou au premier état non binaire (Z) lorsque le deuxième signal (s5) est au deuxième état binaire (H),

- une première étape qui effectue une première combinaison logique (f10·f11·g11·¬g10) du premier, du deuxième, du troisième et du quatrième sous diagramme de décision binaire, de façon à générer un cinquième diagramme de décision binaire (Cd(s11,s5)) qui code un cinquième ensemble de combinaisons d'états des dits troisièmes signaux pour lesquels le premier signal (s11) est à un premier état binaire (B) ou à un deuxième état binaire (H)lorsque le deuxième signal (s5) est au premier état binaire (B), le premier signal (s11) est à un premier état binaire (B) ou à un deuxième état binaire (H)lorsque le deuxième signal (s5) est au deuxième état binaire (H), le premier signal (s11) n'est pas au premier état binaire (B) ou au deuxième état binaire (H) lorsque le deuxième signal (s5) est au premier état binaire (B), le premier signal (s11) est au deuxième état binaire (H) ou au premier état non binaire (Z) lorsque le deuxième signal (s5) est au deuxième état binaire (H), de sorte qu'un passage du dit deuxième signal du premier état binaire (B) au deuxième état binaire (H), respectivement du deuxième état binaire (H) au premier état binaire (B), fait passer ledit premier signal du premier état binaire (B) au deuxième état binaire (H), respectivement du deuxième état binaire (H) au premier état binaire (B).

**7.** Procédé selon la revendication 6, un troisième diagramme de décision binaire (Te(s11)) étant associé au dit premier signal (s11),

- le troisième diagramme de décision binaire (Te(s11)) comprenant :

    - un sixième sous diagramme de décision binaire (e10) codant un sixième ensemble des combinaisons d'états binaires des troisièmes signaux (s6,s7,s8) pour lesquelles le premier signal (s11) est à un deuxième état non binaire (E)lorsque le deuxième signal (s5) est au premier état binaire (B),
    - un septième sous diagramme de décision binaire (e11) codant un septième ensemble des combinaisons d'états binaires des troisièmes signaux (s6,s7,s8) pour lesquelles le premier signal (s11) est à un deuxième état non binaire (E)lorsque le deuxième signal (s5) est au deuxième état binaire (H),

caractérisé en qu'il comprend :

- une deuxième étape qui effectue une deuxième combinaison logique (f10·f11·g11·¬g10·¬e11·¬e10) de la première combinaison logique, du sixième et du septième sous diagramme de décision binaire, de façon à générer le cinquième diagramme de décision binaire (Cd(s11,s5)) qui code alors un sixième ensemble de combinaisons d'états des dits troisièmes signaux pour lesquels de plus, le premier signal (s11) n'est pas à un deuxième état non binaire (E) et le premier signal (s11) n'est pas au deuxième état non binaire (E) lorsque le deuxième signal (s5) est au deuxième état binaire (H), de sorte qu'un passage du dit deuxième signal du premier état binaire (B) au deuxième état binaire (H), respectivement du deuxième état binaire (H) au premier état binaire (B), fait passer ledit premier signal du premier état binaire (B) au deuxième état binaire (H), respectivement du deuxième état binaire (H) au premier état binaire (B).

8. Procédé pour indiquer, en rapport avec un élément physique générant un premier signal (s11) en fonction d'un deuxième signal (s5) et de troisièmes signaux (s6,s7,s8), une combinaison d'états binaires des dits troisièmes signaux telle qu'un changement d'état binaire du dit deuxième signal procure un changement d'état binaire inverse du dit premier signal, deux diagrammes de décision binaire (Tc(s11),Tv(s11)) étant associés au dit premier signal (s11),

   **caractérisé en ce qu'**il comprend :

   - le premier diagramme de décision binaire (Tc(s11)) comprenant :

       - un premier sous diagramme de décision binaire (f10) codant un premier ensemble des combinaisons d'états binaires des troisièmes signaux (s6,s7,s8) pour lesquelles le premier signal (s11) est à un premier état binaire (B) ou à un deuxième état binaire (H)lorsque le deuxième signal (s5) est au premier état binaire (B),
       - un deuxième sous diagramme de décision binaire (f11) codant un deuxième ensemble des combinaisons d'états binaires des troisièmes signaux (s6,s7,s8) pour lesquelles le premier signal (s11) est au premier état binaire (B) ou au deuxième état binaire (H)lorsque le deuxième signal (s5) est au deuxième état binaire (H),

   - le deuxième diagramme de décision binaire (Tv(s11)) comprenant :

       - un troisième sous diagramme de décision binaire (g10) codant un troisième ensemble des combinaisons d'états binaires des troisièmes signaux (s6,s7,s8) pour lesquelles le premier signal (s11) est au deuxième état binaire (H) ou à un premier état non binaire (Z)lorsque le deuxième signal (s5) est au premier état binaire (B),
       - un quatrième sous diagramme de décision binaire (g11) codant un quatrième ensemble des combinaisons d'états binaires des troisièmes signaux (s6,s7,s8) pour lesquelles le premier signal (s11) est au deuxième état binaire (H) ou au premier état non binaire (Z) lorsque le deuxième signal (s5) est au deuxième état binaire (H),

   - une première étape qui effectue une première combinaison logique (f10·f11·g10·¬g11) du premier, du deuxième, du troisième et du quatrième sous diagramme de décision binaire, de façon à générer un cinquième diagramme de décision binaire (Ci(s11,s5)) qui code un cinquième ensemble de combinaisons d'états des dits troisièmes signaux pour lesquels le premier signal (s11) est à un premier état binaire (B) ou à un deuxième état binaire (H)lorsque le deuxième signal (s5) est au premier état binaire (B), le premier signal (s11) est à un premier état binaire (B) ou à un deuxième état binaire (H)lorsque le deuxième signal (s5) est au deuxième état binaire (H), le premier signal (s11) est au premier état binaire (B) ou au deuxième état binaire (H) lorsque le deuxième signal (s5) est au premier état binaire (B), le premier signal (s11) n'est pas au deuxième état binaire (H) ou au premier état non binaire (Z) lorsque le deuxième signal (s5) est au deuxième état binaire (H), de sorte qu'un passage du dit deuxième signal du premier état binaire (B) au deuxième état binaire (H), respectivement du deuxième état binaire (H) au premier état binaire (B), fait passer ledit premier signal du deuxième état binaire (H) au premier état binaire (B), respectivement du premier état binaire (B) au deuxième état binaire (H).

9. Procédé selon la revendication 8, un troisième diagramme de décision binaire (Te(s11)) étant associé au dit premier signal (s11),

   - le troisième diagramme de décision binaire (Te(s11)) comprenant :

       - un sixième sous diagramme de décision binaire (e10) codant un sixième ensemble des combinaisons d'états binaires des troisièmes signaux (s6,s7,s8) pour lesquelles le premier signal (s11) est à un deuxième état non binaire (E)lorsque le deuxième signal (s5) est au premier état binaire (B),

- un septième sous diagramme de décision binaire (e11) codant un septième ensemble des combinaisons d'états binaires des troisièmes signaux (s6,s7,s8) pour lesquelles le premier signal (s11) est à un deuxième état non binaire (E)lorsque le deuxième signal (s5) est au deuxième état binaire (H),

**caractérisé en ce qu'**il comprend :

- une deuxième étape qui effectue une deuxième combinaison logique (f10·f11·g10·¬g11·¬e11·¬e10) de la première combinaison logique, du sixième et du septième sous diagramme de décision binaire, de façon à générer le cinquième diagramme de décision binaire (Ci(s11,s5)) qui code alors un sixième ensemble de combinaisons d'états des dits troisièmes signaux pour lesquels de plus, le premier signal (s11) n'est pas à un deuxième état non binaire (E) lorsque le deuxième signal (s5) est au premier état binaire (B), et le premier signal (s11) n'est pas au deuxième état non binaire (E) lorsque le deuxième signal (s5) est au deuxième état binaire (H), de sorte qu'un passage du dit deuxième signal du premier état binaire (B) au deuxième état binaire (H), respectivement du deuxième état binaire (H) au premier état binaire (B), fait passer ledit premier signal du premier état binaire (B) au deuxième état binaire (H), respectivement du deuxième état binaire (H) au premier état binaire (B).

**10.** Procédé selon la revendication 9, **caractérisé en ce qu'**il comprend:

- une troisième étape (61) qui effectue une première disjonction logique du cinquième et du sixième diagramme de décision binaire pour un premier signal d'entrée (s5),
- une quatrième étape (62) qui effectue une deuxième disjonction logique du cinquième et du sixième diagramme de décision binaire pour un deuxième signal d'entrée (s6)et qui effectue une conjonction logique de la première et de la deuxième disjonction logique,

une cinquième étape qui parcourt le diagramme de décision binaire correspondant à la conjonction logique obtenue dans la quatrième étape si ledit diagramme de décision binaire correspondant, dépend d'états binaires de signaux différents des signaux (s5) et (s6), de façon à obtenir une conjonction logique d'états binaires de signaux (s7,s8,...).

## Claims

**1.** Method for indicating, in connection with a physical element generating a first signal (s11) as a function of a second signal (s5) and of third signals (s6, s7, s8), a combination of states of said third signals such that a change of state of said second signal causes said first signal to change from a binary state to a non-binary state, two binary decision diagrams (Tc(s11),Tv(s11)) being associated with said first signal (s11).
**characterised in that** it comprises:

- the first binary decision diagram (Tc(s11)) comprising:

  - a first binary decision sub-diagram (f10) encoding a first set of the combinations of binary states of the third signals (s6, s7, s8) for which the first signal (s11) is in a first binary state (B) or in a second binary state (H) when the second signal (s5) is in the first binary state (B),

  - a second binary decision sub-diagram (f11) encoding a second set of the combinations of binary states of the third signals (s6, s7, s8) for which the first signal (s11) is in the first binary state (B) or in the second binary state (H) when the second signal (s5) is in the second binary state (H),

- the second binary decision diagram (Tv(s11)) comprising:

  - a third binary decision sub-diagram (g10) encoding a third set of the combinations of binary states of the third signals (s6, s7, s8) for which the first signal (s11) is in the second binary state (H) or in a first non-binary state (Z) when the second signal (s5) is in the first binary state (B),

  - a fourth binary decision sub-diagram (g11) encoding a fourth set of the combinations of binary states of the third signals (s6, s7, s8) for which the first signal (s11) is in the second binary state (H) or in the first non-binary state (Z) when the second signal (s5) is in the second binary state (H),

- a first step that performs a first logical combination (f10·g11·¬f11) of the first, second and fourth binary decision sub-diagrams, so as to generate a fifth binary decision sub-diagram (Cp10) that encodes a fifth set of combinations of states of said third signals for which the first signal (s11) is in a first binary state (B) or in a second binary state (H) when the second signal (s5) is in the first binary state (B), the first signal (s11) is not in the first binary state (B) or in the second binary state (H) when the second signal (s5) is in the second binary state (H), the first signal (s11) is in the second binary state (H) or in the first non-binary state (Z) when the second signal (s5) is in the second binary state (H), so that a change of said second signal from the second binary state (B) to the first binary state (H) causes said first signal to change from a binary state (H, B) to the first non-binary state (Z).

2. Method according to Claim 1, a third binary decision diagram (Te(s11)) being associated with said first signal (s11),

- the third binary decision diagram (Te(s11)) comprising:

  - a sixth binary decision sub-diagram (e10) encoding a sixth set of the combinations of binary states of the third signals (s6, s7, s8) for which the first signal (s11) is in a second non-binary state (E) when the second signal (s5) is in the first binary state (B),

  - a seventh binary decision sub-diagram (e11) encoding a seventh set of the combinations of binary states of the third signals (s6, s7, s8) for which the first signal (s11) is in a second non-binary state (E) when the second signal (s5) is in the second binary state (H),

  **characterised in that** it comprises:

  - a second step that performs a second logical combination (f10·(e11+g11·¬f11)·¬e10) of the first, second, fourth, sixth and seventh binary decision sub-diagrams, so as to generate the fifth binary decision sub-diagram (Cp10), which then encodes an eighth set of combinations of states of said third signals for which the first signal (s11) is in the second binary state (H) or in the first non-binary state (Z) when the second signal (s5) is in the second binary state (H) and the first signal (s11) is not in the first binary state (B) or in the second binary state (H) when the second signal (s5) is in the second binary state (H) or the first signal (s11) is in the second non-binary state (E) when the second signal (s5) is in the second binary state (H), and for which the first signal (s11) is in the first binary state (B) or in the second binary state (H) when the second signal (s5) is in the first binary state (B) and the first signal (s11) is not in the second non-binary state (E) when the second signal (s5) is in the first binary state (B), so that a change of said second signal from the second binary state (H) to the first binary state (B) causes said first signal to change from a binary state (H, B) to the first or the second non-binary state (Z, E).

3. Method according to one of the preceding claims, **characterised in that** it comprises:

- a third step that performs a third logical combination (f11·g10·¬f10) of the first, second and third binary decision sub-diagrams, so as to generate an eighth binary decision sub-diagram (Cp11) that encodes a ninth set of combinations of states of said third signals for which the first signal (s11) is in a first binary state (B) or in a second binary state (H) when the second signal (s5) is in the second binary state (H), the first signal (s11) is not in the first binary state (B) or in the second binary state (H) when the second signal (s5) is in the first binary state (B), the first signal (s11) is in the second binary state (H) or in the first non-binary state (Z) when the second signal (s5) is in the first binary state (B), so that a change of said second signal from the first binary state (H) to the second binary state (B) causes said first signal to change from a binary state (H, B) to the first non-binary state (Z).

4. Method according to one of the preceding claims, **characterised in that** it comprises:

- a fourth step that performs a fourth logical combination (f11·(e10+g10·¬f10)·¬e11) of the first, second, third, sixth and seventh binary decision sub-diagrams, so as to generate the eighth binary decision sub-diagram (Cp11), which then encodes a tenth set of combinations of states of said third signals for which the first signal (s11) is in the second binary state (H) or in the first non-binary state (Z) when the second signal (s5) is in the first binary state (B) and the first signal (s11) is not in the first binary state (B) or in the second binary state (H) when the second signal (s5) is in the first binary state (B) or the first signal (s11) is in the second non-binary state (E) when the second signal (s5) is in the first binary state (B), and for which the first signal (s11) is in the first binary state (B) or in the second binary state (H) when the second signal (s5) is in the second binary state (H) and the first signal (s11) is not in the second non-binary state (E) when the second signal (s5) is in the second binary state (H), so that a change of said second signal from the first binary state (B) to the second binary state (H) causes said first signal to change from a binary state (H, B) to the first or the second non-binary state (Z, E).

5. Method according to Claim 4, **characterised in that** it comprises:

- a fifth step that generates a fourth binary decision diagram (Cp(s11,s5)) constituted by the fifth binary decision sub-diagram (Cp10) when the second signal (s5) is in the first binary state (B) on the one hand, and by the eighth binary decision sub-diagram (Cp11) when the second signal s5 is in the second binary state (H) on the other hand, so that a change of said second signal from the first binary state (B) to the second binary state (H), or respectively of said second signal from the first binary state (B) to the second binary state (H), causes said first signal to change from a binary state (H, B) to the first or the second non-binary state (Z, E).

6. Method for indicating, in connection with a physical element generating a first signal (s11) as a function of a second signal (s5) and of third signals (s6, s7, s8), a combination of binary states of said third signals such that a change of binary state of said second signal produces the same change of binary state of said first signal, two binary decision diagrams (Tc(s11),Tv(s11)) being associated with said first signal (s11).
**characterised in that** it comprises:

- the first binary decision diagram (Tc(s11)) comprising:

- a first binary decision sub-diagram (f10) encoding a first set of the combinations of binary states of the third signals (s6, s7, s8) for which the first signal (s11) is in a first binary state (B) or in a second binary state (H) when the second signal (s5) is in the first binary state (B),

- a second binary decision sub-diagram (f11) encoding a second set of the combinations of binary states of the third signals (s6, s7, s8) for which the first signal (s11) is in the first binary state (B) or in the second binary state (H) when the second signal (s5) is in the second binary state (H),

- the second binary decision diagram (Tv(s11)) comprising:

- a third binary decision sub-diagram (g10) encoding a third set of the combinations of binary states of the third signals (s6, s7, s8) for which the first signal (s11) is in the second binary state (H) or in a first non-binary state (Z) when the second signal (s5) is in the first binary state (B),

- a fourth binary decision sub-diagram (g11) encoding a fourth set of the combinations of binary states of the third signals (s6, s7, s8) for which the first signal (s11) is in the second binary state (H) or in the first non-binary state (Z) when the second signal (s5) is in the second binary state (H),

- a first step that performs a first logical combination (f10·f11·g11·¬g10) of the first, second, third and fourth binary decision sub-diagrams, so as to generate a fifth binary decision diagram (Cd(s11,s5)) encoding a fifth set of combinations of states of said third signals for which the first signal (s11) is in a first binary state (B) or in a second binary state (H) when the second signal (s5) is in the first binary state (B), the first signal (s11) is in a first binary state (B) or in a second binary state (H) when the second signal (s5) is in the second binary state (H), the first signal (s11) is not in the first binary state (B) or in the second binary state (H) when the second signal (s5) is in the first binary state (B), the first signal (s11) is in the second binary state (H) or in the first non-binary state (Z) when the second signal (s5) is in the second binary state (H), so that a change of said second signal from the first binary state (B) to the second binary state (H), or respectively from the second binary state (H) to the first binary state (B), causes said first signal to change from the first binary state (B) to the second binary state (H), or respectively from the second binary state (H) to the first binary state (B).

7. Method according to Claim 6, a third binary decision diagram (Te(s11)) being associated with said first signal (s11),

- the third binary decision diagram (Te(s11)) comprising:

- a sixth binary decision sub-diagram (e10) encoding a sixth set of the combinations of binary states of the third signals (s6, s7, s8) for which the first signal (s11) is in a second non-binary state (E) when the second signal (s5) is in the first binary state (B),

- a seventh binary decision sub-diagram (e11) encoding a seventh set of the combinations of binary states of the third signals (s6, s7, s8) for which the first signal (s11) is in a second non-binary state (E) when the second signal (s5) is in the second binary state (H),

**characterised in that** it comprises:

- a second step that performs a second logical combination (f10·f11·g11·¬g10·¬e11·¬e10) of the first logical combination, and of the sixth and the seventh binary decision sub-diagrams, so as to generate the fifth binary decision diagram (Cd(s11,s5)), which then encodes a sixth set of combinations of states of said third signals for which, moreover, the first signal (s11) is not in a second non-binary state (E) and the first signal (s11) is not in the second non-binary state (E) when the second signal (s5) is in the second binary state (H), so that a change of said second signal from the first binary state (B) to the second binary state (H), or respectively from the second binary state (H) to the first binary state (B), causes said first signal to change from the first binary state (B) to the second binary state (H), or respectively from the second binary state (H) to the first binary state (B).

8. Method for indicating, in connection with a physical element generating a first signal (s11) as a function of a second signal (s5) and of third signals (s6, s7, s8), a combination of binary states of said third signals such that a change of binary state of said second signal produces an inverse change of binary state of said first signal, two binary decision diagrams (Tc(s11),Tv(s11)) being associated with said first signal (s11).

   **characterised in that** it comprises:

   - the first binary decision diagram (Tc(s11)) comprising:

     - a first binary decision sub-diagram (f10) encoding a first set of the combinations of binary states of the third signals (s6, s7, s8) for which the first signal (s11) is in a first binary state (B) or in a second binary state (H) when the second signal (s5) is in the first binary state (B),

     - a second binary decision sub-diagram (f11) encoding a second set of the combinations of binary states of the third signals (s6, s7, s8) for which the first signal (s11) is in the first binary state (B) or in the second binary state (H) when the second signal (s5) is in the second binary state (H),

   - the second binary decision diagram (Tv(s11)) comprising:

     - a third binary decision sub-diagram (g10) encoding a third set of the combinations of binary states of the third signals (s6, s7, s8) for which the first signal (s11) is in the second binary state (H) or in a first non-binary state (Z) when the second signal (s5) is in the first binary state (B),

     - a fourth binary decision sub-diagram (g11) encoding a fourth set of the combinations of binary states of the third signals (s6, s7, s8) for which the first signal (s11) is in the second binary state (H) or in the first non-binary state (Z) when the second signal (s5) is in the second binary state (H),

   - a first step that performs a first logical combination (f10·f11·g10·¬g11) of the first, second, third and fourth binary decision sub-diagrams, so as to generate a fifth binary decision diagram (Ci(s11,s5)) that encodes a fifth set of combinations of states of said third signals for which the first signal (s11) is in a first binary state (B) or in a second binary state (H) when the second signal (s5) is in the first binary state (B), the first signal (s11) is in a first binary state (B) or in a second binary state (H) when the second signal (s5) is in the second binary state (H), the first signal (s11) is in the first binary state (B) or in the second binary state (H) when the second signal (s5) is in the first binary state (B), the first signal (s11) is not in the second binary state (H) or in the first non-binary state (Z) when the second signal (s5) is in the second binary state (H), so that a change of said second signal from the first binary state (B) to the second binary state (H), or respectively from the second binary state (H) to the first binary state (B), causes said first signal to change from the second binary state (H) to the first binary state (B), or respectively from the first binary state (B) to the second binary state (H).

9. Method according to Claim 8, a third binary decision diagram (Te(s11)) being associated with said first signal (s11),

   - the third binary decision diagram (Te(s11)) comprising:

      - a sixth binary decision sub-diagram (e10) encoding a sixth set of the combinations of binary states of the third signals (s6, s7, s8) for which the first signal (s11) is in a second non-binary state (E) when the second signal (s5) is in the first binary state (B),

      - a seventh binary decision sub-diagram (e11) encoding a seventh set of the combinations of binary states of the third signals (s6, s7, s8) for which the first signal (s11) is in a second non-binary state (E) when the second signal (s5) is in the second binary state (H),

   **characterised in that** it comprises:

   - a second step that performs a second logical combination ($f10 \cdot f11 \cdot g10 \cdot \neg g11 \cdot \neg e11 \cdot \neg e10$) of the first logical combination, and of the sixth and the seventh binary decision sub-diagrams, so as to generate the fifth binary decision diagram (Ci(s11,s5)), which then encodes a sixth set of combinations of states of said third signals for which, moreover, the first signal (s11) is not in a second non-binary state (E) when the second signal (s5) is in the first binary state (B), and the first signal (s11) is not in the second non-binary state (E) when the second signal (s5) is in the second binary state (H), so that a change of said second signal from the first binary state (B) to the second binary state (H), or respectively from the second binary state (H) to the first binary state (B), causes said first signal to change from the first binary state (B) to the second binary state (H), or respectively from the second binary state (H) to the first binary state (B).

10. Method according to Claim 9, **characterised in that** it comprises:

   a third step (61), which performs a first logical disjunction of the fifth and sixth binary decision diagrams for a first input signal (s5),

   a fourth step (62), which performs a second logical disjunction of the fifth and sixth binary decision diagrams for a second input signal (s6) and which performs a logical conjunction of the first and second logical disjunctions,

   a fifth step, which scans the binary decision diagram corresponding to the logical conjunction obtained in the fourth step if said corresponding binary decision diagram depends on binary states of signals different from the signals (s5) and (s6), so as to obtain a logical conjunction of binary states of signals (s7, s8, ...).

**Patentansprüche**

1. Verfahren, um in Bezug auf ein physikalisches Element, das ein erstes Signal (s11) in Abhängigkeit von einem zweiten Signal (s5) und von dritten Signalen (s6, s7, s8) erzeugt, eine Kombination von Zuständen dieser dritten Signale anzugeben, derart, dass eine Änderung des Zustandes des zweiten Signals einen Übergang des ersten Signals von einem binären Zustand in einen nicht binären Zustand bewirkt, wobei dem ersten Signal (s11) zwei binäre Entscheidungsdiagramme (Tc(s11), Tv(s11)) zugeordnet sind,
   **dadurch gekennzeichnet, dass**

   - das erste binäre Entscheidungsdiagramm (Tc(s11)) umfasst:

      - ein erstes binäres Unterentscheidungsdiagramm (f10), das eine erste Gesamtheit von Kombinationen binärer Zustände der dritten Signale (s6, s7, s8) codiert, für die das erste Signal (s11) in einem ersten binären Zustand (B) oder in einem zweiten binären Zustand (H) ist, wenn das zweite Signal (s5) in dem ersten binären Zustand (B) ist,

      - ein zweites binäres Unterentscheidungsdiagramm (f11), das eine zweite Gesamtheit von Kombinationen binärer Zustände der dritten Signale (s6, s7, s8) codiert, für die das erste Signal (s11) in dem ersten binären Zustand (B) oder in dem zweiten binären Zustand (H) ist, wenn das zweite Signal (s5) in dem zweiten binären Zustand (H) ist,

- das zweite binäre Entscheidungsdiagramm (Tv(s11)) umfasst:

    - ein drittes binäres Unterentscheidungsdiagramm (g10), das eine dritte Gesamtheit von Kombinationen binärer Zustände der dritten Signale (s6, s7, s8) codiert, für die das erste Signal (s11) im zweiten binären Zustand (H) oder in einem ersten nicht binären Zustand (Z) ist, wenn das zweite Signal (s5) in dem ersten binären Zustand (B) ist,
    - ein viertes binäres Unterentscheidungsdiagramm (g11), das eine vierte Gesamtheit von Kombinationen binärer Zustände der dritten Signale (s6, s7, s8) codiert, für die das erste Signal (s11) in dem zweiten binären Zustand (H) oder in dem ersten nicht binären Zustand (Z) ist, wenn das zweite Signal (s5) in dem zweiten binären Zustand (H) ist,

- und dass es einen ersten Schritt umfasst, der eine erste logische Kombination (f10· g11 · ¬f11) des ersten, des zweiten und des vierten binären Unterentscheidungsdiagramms in der Weise ausführt, dass ein fünftes binäres Unterentscheidungsdiagramm (Cp10) erzeugt wird, das eine fünfte Gesamtheit von Kombinationen von Zuständen der dritten Signale codiert, für die das erste Signal (s11) in einem ersten binären Zustand (B) oder in einem zweiten binären Zustand (H) ist, wenn das zweite Signal (s5) in dem ersten binären Zustand (B) ist, das erste Signal (s11) nicht in dem ersten binären Zustand (B) oder in dem zweiten binären Zustand (H) ist, wenn das zweite Signal (s5) in dem zweiten binären Zustand (H) ist, und das erste Signal (s11) in dem zweiten binären Zustand (H) oder in dem nicht binären Zustand (Z) ist, wenn das zweite Signal (s5) in dem zweiten binären Zustand (H) ist, derart, dass ein Übergang des zweiten Signals von dem zweiten binären Zustand (B) in den ersten binären Zustand (H) einen Übergang des ersten Signals von einem binären Zustand (H, B) in den ersten nicht binären Zustand (Z) bewirkt.

2. Verfahren nach Anspruch 1, bei dem dem ersten Signal (s11) ein drittes binäres Entscheidungsdiagramm (Te(s11)) zugeordnet ist,

    - wobei das dritte binäre Entscheidungsdiagramm (Te(s11)) umfasst:

        - ein sechstes binäres Unterentscheidungsdiagramm (e10), das eine sechste Gesamtheit von Kombinationen binärer Zustände der dritten Signale (s6, s7, s8) codiert, für die das erste Signal (s11) in einem zweiten nicht binären Zustand (E) ist, wenn das zweite Signal (s5) in dem ersten binären Zustand (B) ist,
        - ein siebtes binäres Unterentscheidungsdiagramm (e11), das eine siebte Gesamtheit von Kombinationen binärer Zustände der dritten Signale (s6, s7, s8) codiert, für die das erste Signal (s11) in einem zweiten nicht binären Zustand (E) ist, wenn das zweite Signal (s5) in dem zweiten binären Zustand (H) ist,

        **dadurch gekennzeichnet, dass** es umfasst:

    - einen zweiten Schritt, der eine zweite logische Kombination (f10· (e11 + g11 · ¬f11) · ¬e10) des ersten, des zweiten, des vierten, des sechsten und des siebten binären Unterentscheidungsdiagramms in der Weise ausführt, dass das fünfte binäre Unterentscheidungsdiagramm (Cp10) erzeugt wird, das dann eine achte Gesamtheit von Kombinationen von Zuständen der dritten Signale codiert, für die das erste Signal (s11) in dem zweiten binären Zustand (H) oder in dem ersten nicht binären Zustand (Z) ist, wenn das zweite Signal (s5) in dem zweiten binären Zustand (H) ist, und das erste Signal (s11) nicht in dem ersten binären Zustand (B) oder in dem zweiten binären Zustand (H) ist, wenn das zweite Signal (s5) in dem zweiten binären Zustand (H) ist, oder das erste Signal (s11) in dem zweiten nicht binären Zustand (H) ist, wenn das zweite Signal (s5) in dem zweiten binären Zustand (H) ist, und für die das erste Signal (s11) in dem ersten binären Zustand (B) oder in dem zweiten binären Zustand (H) ist, wenn das zweite Signal (s5) in dem ersten binären Zustand (B) ist, und das erste Signal (s11) nicht in dem zweiten nicht binären Zustand (E) ist, wenn das zweite Signal (s5) in dem ersten binären Zustand (B) ist, derart, dass ein Übergang des zweiten Signals von dem zweiten binären Zustand (H) in den ersten binären Zustand (B) einen Übergang des ersten Signals von einem binären Zustand (H, B) in den ersten oder den zweiten nicht binären Zustand (Z, E) bewirkt.

3. Verfahren nach einem der vorhergehenden Ansprüche, **dadurch gekennzeichnet, dass** es umfasst:

    - einen dritten Schritt, der eine dritte logische Kombination (f11· g10· ¬f10) des ersten, des zweiten und des dritten binären Unterentscheidungsdiagramms in der Weise ausführt, dass ein achtes binäres Unterentscheidungsdiagramm (Cp11) erzeugt wird, das eine neunte Gesamtheit von Kombinationen von Zuständen der dritten Signale codiert, für die das erste Signal (s 11) in einem ersten binären Zustand (B) oder in einem zweiten

27

binären Zustand (H) ist, wenn das zweite Signal (s5) in dem zweiten binären Zustand (H) ist, das erste Signal (s11) nicht in dem ersten binären Zustand (B) oder in dem zweiten binären Zustand (H) ist, wenn das zweite Signal (s5) in dem ersten binären Zustand (B) ist, und das erste Signal (s11) in dem zweiten binären Zustand (H) oder in dem ersten nicht binären Zustand (Z) ist, wenn das zweite Signal (s5) in dem ersten binären Zustand (B) ist, derart, dass ein Übergang des zweiten Signals von dem ersten binären Zustand (H) in den zweiten binären Zustand (B) einen Übergang des ersten Signals von einem binären Zustand (H, B) in den ersten nicht binären Zustand (Z) bewirkt.

4. Verfahren nach einem der vorhergehenden Ansprüche, **dadurch gekennzeichnet, dass** es umfasst:

- einen vierten Schritt, der eine vierte logische Kombination (f11· (e10 + g10· ¬f10)· ¬e11) des ersten, des zweiten, des dritten, des sechsten und des siebten binären Unterentscheidungsdiagramms in der Weise ausführt, dass das achte binäre Unterentscheidungsdiagramm (Cp11) erzeugt wird, das dann eine zehnte Gesamtheit von Kombinationen von Zuständen der dritten Signale codiert, für die das erste Signal (s11) in dem zweiten binären Zustand (H) oder in dem ersten nicht binären Zustand (Z) ist, wenn das zweite Signal (s5) in dem ersten binären Zustand (B) ist, und das erste Signal (s11) nicht in dem ersten binären Zustand (B) oder in dem zweiten binären Zustand (H) ist, wenn das zweite Signal (s5) in dem ersten binären Zustand (B) ist, oder das erste Signal (s11) in dem zweiten nicht binären Zustand (H) ist, wenn das zweite Signal (s5) in dem ersten binären Zustand (B) ist, und für die das erste Signal (s11) in dem ersten binären Zustand (B) oder in dem zweiten binären Zustand (H) ist, wenn das zweite Signal (s5) in dem zweiten binären Zustand (H) ist, und das erste Signal (s11) nicht in dem zweiten nicht binären Zustand (E) ist, wenn das zweite Signal (s5) in dem zweiten binären Zustand (H) ist, derart, dass ein Übergang des zweiten Signals von dem ersten binären Zustand (B) in den zweiten binären Zustand (H) einen Übergang des ersten Signals von einem binären Zustand (H, B) in den ersten oder den zweiten nicht binären Zustand (Z, E) bewirkt.

5. Verfahren nach Anspruch 4, **dadurch gekennzeichnet, dass** es umfasst:

- einen fünften Zustand, der ein viertes binäres Entscheidungsdiagramm (Cp(s11, s5)) erzeugt, das entweder aus dem fünften binären Unterentscheidungsdiagramm (Cp10) gebildet ist, wenn das zweite Signal (s5) in dem ersten binären Zustand (B) ist, oder aus dem achten binären Unterentscheidungsdiagramm (Cp11) gebildet ist, wenn das zweite Signal (s5) in dem zweiten binären Zustand (H) ist, derart, dass ein Übergang des zweiten Signals von dem ersten binären Zustand (B) in den zweiten binären Zustand (H) bzw. des zweiten Signals von dem ersten binären Zustand (B) in den zweiten binären Zustand (H) einen Übergang des ersten Signals von einem binären Zustand (H, B) in den ersten oder den zweiten nicht binären Zustand (Z, E) bewirkt.

6. Verfahren, um in Bezug auf ein physikalisches Element, das ein erstes Signal (s11) in Abhängigkeit von einem zweiten Signal (s5) und von dritten Signalen (s6, s7, s8) erzeugt, eine Kombination binärer Zustände der dritten Signale anzugeben, derart, dass eine Änderung des binären Zustandes des zweiten Signals die gleiche Änderung des binären Zustandes des ersten Signals bewirkt, wobei dem ersten Signal (s11) zwei binäre Entscheidungsdiagramme (Tc(s11), Tv(s11)) zugeordnet sind,
**dadurch gekennzeichnet, dass**

- das erste binäre Entscheidungsdiagramm (Tc(s11)) umfasst:

  - ein erstes binäres Unterentscheidungsdiagramm (f10), das eine erste Gesamtheit von Kombinationen binärer Zustände der dritten Signale (s6, s7, s8) codiert, für die das erste Signal (s11) in einem ersten binären Zustand (B) oder in einem zweiten binären Zustand (H) ist, wenn das zweite Signal (s5) in dem ersten binären Zustand (B) ist,

  - ein zweites binäres Unterentscheidungsdiagramm (f11), das eine zweite Gesamtheit von Kombinationen binärer Zustände der dritten Signale (s6, s7, s8) codiert, für die das erste Signal (s11) in dem ersten binären Zustand (B) oder in dem zweiten binären Zustand (H) ist, wenn das zweite Signal (s5) in dem zweiten binären Zustand (H) ist,

- das zweite binäre Entscheidungsdiagramm (Tv(s11)) umfasst:

  - ein drittes binäres Unterentscheidungsdiagramm (g10), das eine dritte Gesamtheit von Kombinationen binärer Zustände der dritten Signale (s6, s7, s8) codiert, für die das erste Signal (s11) in dem zweiten binären Zustand (H) oder in einem ersten nicht binären Zustand (Z) ist, wenn das zweite Signal (s5) in dem ersten binären Zustand (B) ist,

- ein viertes binäres Unterentscheidungsdiagramm (g11), das eine vierte Gesamtheit von Kombinationen binärer Zustände der dritten Signale (s6, s7, s8) codiert, für die das erste Signal (s11) in dem zweiten binären Zustand (H) oder in dem ersten nicht binären Zustand (Z) ist, wenn das zweite Signal (s5) in dem zweiten binären Zustand (H) ist,

- und dass es einen ersten Schritt umfasst, der eine erste logische Kombination (f10· f11· g11· ¬g10) des ersten, des zweiten, des dritten und des vierten binären Unterentscheidungsdiagramms in der Weise ausführt, dass ein fünftes binäres Entscheidungsdiagramm (Cd(s11, s5)) erzeugt wird, das eine fünfte Gesamtheit von Kombinationen von Zuständen der dritten Signale codiert, für die das erste Signal (s11) in einem ersten binären Zustand (B) oder in einem zweiten binären Zustand (H) ist, wenn das zweite Signal (s5) in dem ersten binären Zustand (B) ist, das erste Signal (s11) in einem ersten binären Zustand (B) oder in einem zweiten binären Zustand (H) ist, wenn das zweite Signal (s5) in dem zweiten binären Zustand (H) ist, das erste Signal (s11) nicht in dem ersten binären Zustand (B) oder dem zweiten binären Zustand (H) ist, wenn das zweite Signal (s5) in dem ersten binären Zustand (B) ist, und das erste Signal (s11) in dem zweiten binären Zustand (H) oder in dem ersten nicht binären Zustand (Z) ist, wenn das zweite Signal (s5) in dem zweiten binären Zustand (H) ist, derart, dass ein Übergang des zweiten Signals von dem ersten binären Zustand (B) in den zweiten binären Zustand (H) bzw. von dem zweiten binären Zustand (H) in den ersten binären Zustand (B) einen Übergang des ersten Signals von dem ersten binären Zustand (B) in den zweiten binären Zustand (H) bzw. von dem zweiten binären Zustand (H) in den ersten binären Zustand (B) bewirkt.

7. Verfahren nach Anspruch 6, bei dem dem ersten Signal (s11) ein drittes binäres Entscheidungsdiagramm (Te(s11)) zugeordnet ist,

- wobei das dritte binäre Entscheidungsdiagramm (Te(s11)) umfasst:

- ein sechstes binäres Unterentscheidungsdiagramm (e10), das eine sechste Gesamtheit von Kombinationen binärer Zustände der dritten Signale (s6, s7, s8) codiert, für die das erste Signal (s11) in einem zweiten nicht binären Zustand (E) ist, wenn das zweite Signal (s5) in dem ersten binären Zustand (B) ist,

- ein siebtes binäres Unterentscheidungsdiagramm (e11), das eine siebte Gesamtheit von Kombinationen binärer Zustände der dritten Signale (s6, s7, s8) codiert, für die das erste Signal (s11) in einem zweiten nicht binären Zustand (E) ist, wenn das zweite Signal (s5) in dem zweiten binären Zustand (H) ist,

**dadurch gekennzeichnet, dass** es umfasst:

- einen zweiten Schritt, der eine zweite logische Kombination (f10· f11· g11· ¬g10· ¬e11 · ¬e10) der ersten logischen Kombination, des sechsten und des siebten binären Unterentscheidungsdiagramms in der Weise ausführt, dass das fünfte binäre Entscheidungsdiagramm (Cd(s11, s5)) erzeugt wird, das dann eine sechste Gesamtheit von Kombinationen von Zuständen der dritten Signale codiert, für die außerdem das erste Signal (s11) nicht in einem zweiten nicht binären Zustand (E) ist und das erste Signal (s11) nicht in dem zweiten nicht binären Zustand (E) ist, wenn das zweite Signal (s5) in dem zweiten binären Zustand (H) ist, derart, dass ein Übergang des zweiten Signals von dem ersten binären Zustand (B) in den zweiten binären Zustand (H) bzw. von dem zweiten binären Zustand (H) in den ersten binären Zustand (B) einen Übergang des ersten Signals von dem ersten binären Zustand (B) in den zweiten binären Zustand (H) bzw. von dem zweiten binären Zustand (H) in den ersten binären Zustand (B) bewirkt.

8. Verfahren, um in Bezug auf ein physikalisches Element, das ein erstes Signal (s11) in Abhängigkeit von einem zweiten Signal (s5) und von dritten Signalen (s6, s7, s8) erzeugt, eine Kombination binärer Zustände der dritten Signale anzugeben, derart, dass eine Änderung des binären Zustandes des zweiten Signals eine entgegengesetzte Änderung des binären Zustandes des ersten Signals bewirkt, wobei dem ersten Signal (s11) zwei binäre Entscheidungsdiagramme (Tc(s11), Tv(s11)) zugeordnet sind,
**dadurch gekennzeichnet, dass**

- das erste binäre Entscheidungsdiagramm (Tc(s11)) umfasst:

- ein erstes binäres Unterentscheidungsdiagramm (f10), das eine erste Gesamtheit von Kombinationen binärer Zustände der dritten Signale (s6, s7, s8) codiert, für die das erste Signal (s11) in einem ersten binären Zustand (B) oder in einem zweiten binären Zustand (H) ist, wenn das zweite Signal (s5) in dem ersten binären Zustand (B) ist,

- ein zweites binäres Unterentscheidungsdiagramm (f11), das eine zweite Gesamtheit von Kombinationen binärer Zustände der dritten Signale (s6, s7, s8) codiert, für die das erste Signal (s11) in dem ersten binären Zustand (B) oder in dem zweiten binären Zustand (H) ist, wenn das zweite Signal (s5) in dem zweiten binären Zustand (H) ist,

- das zweite binäre Entscheidungsdiagramm (Tv(s11)) umfasst:

  - ein drittes binäres Unterentscheidungsdiagramm (g10), das eine dritte Gesamtheit von Kombinationen binärer Zustände der dritten Signale (s6, s7, s8) codiert, für die das erste Signal (s11) in dem zweiten binären Zustand (H) oder in einem ersten nicht binären Zustand (Z) ist, wenn das zweite Signal (s5) in dem ersten binären Zustand (B) ist,

  - ein viertes binäres Unterentscheidungsdiagramm (g11), das eine vierte Gesamtheit von Kombinationen binärer Zustände der dritten Signale (s6, s7, s8) codiert, für die das erste Signal (s11) in dem zweiten binären Zustand (H) oder in dem ersten nicht binären Zustand (Z) ist, wenn das zweite Signal (s5) in dem zweiten binären Zustand (H) ist,

- und dass es einen ersten Schritt umfasst, der eine erste logische Kombination (f10· f11· g10· ¬g11) des ersten, des zweiten, des dritten und des vierten Unterentscheidungsdiagramms in der Weise ausführt, dass ein fünftes binäres Entscheidungsdiagramm (Ci(s11, s5)) erzeugt wird, das eine fünfte Gesamtheit von Kombinationen von Zuständen der dritten Signale codiert, für die das erste Signal (s11) in einem ersten binären Zustand (B) oder in einem zweiten binären Zustand (H) ist, wenn das zweite Signal (s5) in dem ersten binären Zustand (B) ist, das erste Signal (s11) in einem ersten binären Zustand (B) oder in einem zweiten binären Zustand (H) ist, wenn das zweite Signal (s5) in dem zweiten binären Zustand (H) ist, das erste Signal (s11) in dem ersten binären Zustand (B) oder in dem zweiten binären Zustand (H) ist, wenn das zweite Signal (s5) in dem ersten binären Zustand (B) ist, und das erste Signal (s11) nicht in dem zweiten binären Zustand (H) oder in dem ersten nicht binären Zustand (Z) ist, wenn das zweite Signal (s5) in dem zweiten binären Zustand (H) ist, derart, dass ein Übergang des zweiten Signals von dem ersten binären Zustand (B) in den zweiten binären Zustand (H) bzw. von dem zweiten binären Zustand (H) in den ersten binären Zustand (B) einen Übergang des ersten Signals von dem zweiten binären Zustand (H) in den ersten binären Zustand (B) bzw. von dem ersten binären Zustand (B) in den zweiten binären Zustand (H) bewirkt.

9. Verfahren nach Anspruch 8, bei dem dem ersten Signal (s11) ein drittes binäres Entscheidungsdiagramm (Te(s11)) zugeordnet ist,

- wobei das dritte binäre Entscheidungsdiagramm (Te(s11)) umfasst:

  - ein sechstes binäres Unterentscheidungsdiagramm (e10), das eine sechste Gesamtheit von Kombinationen binärer Zustände der dritten Signale (s6, s7, s8) codiert, für die das erste Signal (s11) in einem zweiten nicht binären Zustand (E) ist, wenn das zweite Signal (s5) in dem ersten binären Zustand (B) ist,

  - ein siebtes binäres Unterentscheidungsdiagramm (e11), das eine siebte Gesamtheit von Kombinationen binärer Zustände der dritten Signale (s6, s7, s8) codiert, für die das erste Signal (s11) in einem zweiten nicht binären Zustand (E) ist, wenn das zweite Signal (s5) in dem zweiten binären Zustand (H) ist,

  **dadurch gekennzeichnet, dass** es

- einen zweiten Schritt umfasst, der eine zweite logische Kombination (f10·f11·g10·¬f11·¬e11·¬e10) der ersten logischen Kombination, des sechsten und des siebten binären Unterentscheidungsdiagramms in der Weise ausführt, dass das fünfte binäre Entscheidungsdiagramm (Ci(s11, s5)) erzeugt wird, das dann eine sechste Gesamtheit von Kombinationen von Zuständen der dritten Signale codiert, für die außerdem das erste Signal (s11) nicht in einem zweiten nicht binären Zustand (E) ist, wenn das zweite Signal (s5) in dem ersten binären Zustand (B) ist, und das erste Signal (s11) nicht in dem zweiten nicht binären Zustand (E) ist, wenn das zweite Signal (s5) in dem zweiten binären Zustand (H) ist, derart, dass ein Übergang des zweiten Signals von dem ersten binären Zustand (B) in den zweiten binären Zustand (H) bzw. von dem zweiten binären Zustand (H) in den ersten binären Zustand (B) einen Übergang des ersten Signals von dem ersten binären Zustand (B) in den zweiten binären Zustand (H) bzw. von dem zweiten binären Zustand (H) in den ersten binären Zustand (B) bewirkt.

10. Verfahren nach Anspruch 9, **dadurch gekennzeichnet, dass** es umfasst:

- einen dritten Schritt (61), der für ein erstes Eingangssignal (s5) eine erste logische Disjunktion des fünften und des sechsten binären Entscheidungsdiagramms ausführt,

- einen vierten Schritt (62), der für ein zweites Eingangssignal (s6) eine zweite logische Disjunktion des fünften und des sechsten binären Entscheidungsdiagramms ausführt und eine logische Konjunktion der ersten und der zweiten logischen Disjunktion ausführt,

einen fünften Schritt, der das binäre Entscheidungsdiagramm, das der in dem vierten Schritt erhaltenen logischen Konjunktion entspricht, durchläuft, falls das entsprechende Entscheidungsdiagramm von den binären Zuständen der verschiedenen Signale der Signale (s5) und (s6) abhängt, derart, dass eine logische Konjunktion binärer Zustände von Signalen (s7, s8, ...) erhalten wird.

EP 1 292 840 B1

**Fig.1**

$S_i$

$(x_{vi}, x_{ci}) \rightarrow S_i$ — 1

$T_c(S_i) \rightarrow S_i$
$T_v(S_i) \rightarrow S_i$
$T_e(S_i) \rightarrow S_i$ — 2

non

$x_{ci} = ? \Phi_c(x_{ci+1}, x_{vi+1}, \ldots)$
$x_{vi} = ? \Phi_v(x_{ci+1}, x_{vi+1}, \ldots)$
$(x_{vi}, x_{ci}) = ?$
$\Phi_e(x_{ci+1}, x_{vi+1}, \ldots)$ — 3

oui

$S_{i+1}$ — 4

$T_c(S_i) = \Phi_c(T_c(S_{i+1}), T_v(S_{i+1}), \ldots)$
$T_v(S_i) = \Phi_v(T_c(S_{i+1}), T_v(S_{i+1}), \ldots)$
$T_e(S_i) = \Phi_e(T_c(S_{i+1}), T_v(S_{i+1}), T_e(S_{i+1}), \ldots)$ — 5

Retour — 6

**Fig.2**

$S_i$

Cpi0=
fi0·gi1·¬fi1          7

Cpi1=
Fi1·gi0·¬fi0          9

Cpi0=
fi0·(ei1+gi1·¬fi1)·¬ei0          8

Cpi1=
fi1·(ei0+gi0·¬fi0)·¬ei1          10

$Cp(S_i, s_j)=$
$\{x_{vj}, Cpi0, Cpi1\}$          11

$Cd(S_i, s_j)=$
fi0·fi1·gi1·¬gi0          12

$Ci(S_i, s_j)=$
fi0·fi1·gi0·¬gi1          14

$Cd(S_i, s_j)=$
fi0·fi1·gi1·¬gi0·¬ei1·¬ei0          13

$Ci(S_i, s_j)=$
fi0·fi1·gi0·¬gi1·¬ei1·¬ei0          15

**Fig.3**

**Fig.4**

**Fig.5**

**Fig.6**

**Fig.7**

# Fig.8

$S_{11}$

$S(S_{11}, S_5)=$
$Cd(S_{11}, S_5)+ Ci(S_{11}, S_5)$ — 61

$S(S_{11}, S_5)=$
$Cd(S_{11}, S_6)+ Ci(S_{11}, S_6)$
$S(S_{11}, S_5, S_6)=$
$S(S_{11}, S_5) \cdot S(S_{11}, S_5)$ — 62

$S(S_{11}, S_5, S_6)=?$
$A(xv7, xv8, \ldots)$ — 63

non

oui

$\{xv7, xv8, \ldots\}$
/
$A(xv7, xv8, \ldots)=1$ — 64